(19)

Europäisches
Patentamt
European
Patent Office
Office européen
des brevets

(11)   EP 4 693 887 A1

(12)   EUROPEAN PATENT APPLICATION
published in accordance with Art. 153(4) EPC

(43) Date of publication:
11.02.2026   Bulletin 2026/07

(21) Application number: 24780893.4

(22) Date of filing: 29.03.2024

(51) International Patent Classification (IPC):
H02P 29/024 (2016.01)

(52) Cooperative Patent Classification (CPC):
H02P 29/024

(86) International application number:
PCT/JP2024/013257

(87) International publication number:
WO 2024/204799 (03.10.2024 Gazette 2024/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority:   31.03.2023   JP 2023059339

(71) Applicant: Daikin Industries, Ltd.
Osaka-shi, Osaka 530-0001 (JP)

(72) Inventors:
• KOBORI, Hirokazu
Osaka-shi, Osaka 530-0001 (JP)
• ARAKI, Takeshi
Osaka-shi, Osaka 530-0001 (JP)
• OGAWA, Takuro
Osaka-shi, Osaka 530-0001 (JP)

(74) Representative: Hoffmann Eitle
Patent- und Rechtsanwälte PartmbB
Arabellastraße 30
81925 München (DE)

(54)   **STATE ESTIMATION DEVICE, DRIVE SYSTEM, REFRIGERATION SYSTEM, FAN SYSTEM, STATE ESTIMATION METHOD, AND STATE ESTIMATION PROGRAM**

(57)   In a calculation process, a control unit (31) calculates a feature quantity from a physical quantity obtained from a device (70) within a predetermined period. In an estimation process, the control unit (31) estimates the state of the device (70), based on the feature quantity calculated by the calculation process. In a restriction process, the control unit (31) restricts the estimation process when an estimation restriction condition is satisfied, maintains restriction of the estimation process until a standby release condition is satisfied when a restriction release condition is satisfied, and releases the restriction of the estimation process after the standby release condition is satisfied. The estimation restriction condition is a condition in which there is a possibility of occurrence of erroneous estimation in the estimation process. The restriction release condition is a condition in which the erroneous estimation in the estimation process is suppressed.

FIG.2

## Description

Technical Field

The present disclosure relates to a state estimation technique.

Background Art

PTL 1 discloses an abnormality diagnosis device for a rotary machine driven by a motor. The abnormality diagnosis device includes a parameter acquisition unit that acquires, from a frequency spectrum acquired based on a transition of a current value of the motor, a parameter indicating the shape of the frequency spectrum, and an abnormality determination unit that diagnoses an abnormality of the rotary machine based on the parameter.

Citation List

Patent Literature

PTL 1: Japanese Unexamined Patent Application Publication No. 2020-67334

Summary of Invention

Technical Problem

In a state estimation device (a device for estimating the state of a device) such as the abnormality diagnosis device in PTL 1, if an unintended variation (noise) occurs in a feature quantity used to estimate the state of the device, the state of the device is difficult to accurately estimate based on the feature quantity, which may result in erroneous estimation of the state of the device. For example, in a case where the state estimation device estimates the presence or absence of an abnormality of a device, there is a possibility of erroneously estimating that the device is abnormal although the device is normal.

Solution to Problem

A first aspect of the present disclosure relates to a state estimation device for estimating a state of a device (70) including a motor (50). The state estimation device includes a control unit (31). The control unit (31) is configured to perform a calculation process for calculating a feature quantity from a physical quantity obtained from the device (70) within a predetermined period, an estimation process for estimating the state of the device (70), based on the feature quantity calculated by the calculation process, and a restriction process for restricting the estimation process so that a predetermined estimation result is output when a predetermined estimation restriction condition is satisfied, maintaining restriction of the estimation process until a predetermined standby release condition is satisfied when a predetermined restriction release condition is satisfied, and releasing the restriction of the estimation process after the predetermined standby release condition is satisfied. The physical quantity is a quantity that varies in accordance with rotation of the motor (50). The feature quantity is a quantity that varies in accordance with the state of the device (70). The state of the device (70) includes at least one of an abnormality of the motor (50), a degree of deterioration of the motor (50), an abnormality of an element driven by the motor (50), and a degree of deterioration of the element driven by the motor (50). The estimation restriction condition is a condition in which there is a possibility of occurrence of erroneous estimation in the estimation process. The restriction release condition is a condition in which the erroneous estimation in the estimation process is suppressed.

In the first aspect, the estimation process is restricted so that a predetermined estimation result is output when a predetermined estimation restriction condition is satisfied. Thus, the erroneous estimation of the state of the device (70) can be appropriately suppressed. In addition, by restricting the estimation process based on the satisfaction of a predetermined restriction release condition, it is possible to appropriately release the restriction of the estimation process.

In the first aspect, when a predetermined restriction release condition is satisfied, the restriction of the estimation process is maintained until a predetermined standby release condition is satisfied, and, after the predetermined standby release condition is satisfied, the restriction of the estimation process is released. This configuration can release the restriction of the estimation process after stabilizing the feature quantity calculated in the calculation process, compared to a case where the restriction of the estimation process is released without waiting for the predetermined standby release condition to be satisfied. Thus, it is possible to suppress erroneous estimation of the state of the device (70) after the restriction of the estimation process is released.

A second aspect of the present disclosure provides the state estimation device according to the first aspect, in which the restriction release condition is a condition that a number of rotations of the motor (50) changes from an unsteady state to a steady state.

In the second aspect, the state of the number of rotations of the motor (50) correlates with an unintended variation that occurs in the feature quantity calculated from the physical quantity obtained from the device (70) within the predetermined period. By monitoring the state of the number of rotations of the motor (50), it is possible to check whether an unintended variation is occurring in the feature quantity. Thus, by releasing the restriction of the estimation process based on the change in the state of the number of rotations of the motor (50), it is possible to appropriately release the restriction of the estimation process.

A third aspect of the present disclosure provides the state estimation device according to the first aspect, in which the device (70) includes a compressor (CC) including the motor (50), and the restriction release condition is a condition that a pressure of a fluid flowing into the compressor (CC) or a pressure of a fluid flowing out of the compressor (CC) changes from an unsteady state to a steady state.

In the third aspect, the state of the pressure of the fluid flowing into the compressor (CC) or the pressure of the fluid flowing out of the compressor (CC) correlates with an unintended variation that occurs in the feature quantity calculated from the physical quantity obtained from the device (70) within the predetermined period. By monitoring the state of the pressure of the fluid flowing into the compressor (CC) or the pressure of the fluid flowing out of the compressor (CC), it is possible to check whether an unintended variation is occurring in the feature quantity. Thus, by releasing the restriction of the estimation process based on the change in the state of the pressure of the fluid flowing into the compressor (CC) or the pressure of the fluid flowing out of the compressor (CC), it is possible to appropriately release the restriction of the estimation process.

A fourth aspect of the present disclosure provides the state estimation device according to the first aspect, in which the device (70) includes a compressor (CC) including the motor (50), and the restriction release condition is a condition that a temperature of a fluid flowing into the compressor (CC) or a temperature of a fluid flowing out of the compressor (CC) changes from an unsteady state to a steady state.

In the fourth aspect, the state of the temperature of the fluid flowing into the compressor (CC) or the temperature of the fluid flowing out of the compressor (CC) correlates with an unintended variation that occurs in the feature quantity calculated from the physical quantity obtained from the device (70) within the predetermined period. By monitoring the state of the temperature of the fluid flowing into the compressor (CC) or the temperature of the fluid flowing out of the compressor (CC), it is possible to check whether an unintended variation is occurring in the feature quantity. Thus, by releasing the restriction of the estimation process based on the change in the state of the temperature of the fluid flowing into the compressor (CC) or the temperature of the fluid flowing out of the compressor (CC), it is possible to appropriately release the restriction of the estimation process.

A fifth aspect of the present disclosure provides the state estimation device according to the first aspect, in which the restriction release condition is a first condition that a control mode of the motor (50) changes after the estimation process is restricted, or a second condition that, when the estimation restriction condition is a condition that the control mode of the motor (50) changes, the estimation process is restricted in accordance with a change in the control mode of the motor (50).

In the fifth aspect, the change in the control mode of the motor (50) correlates with an unintended variation that occurs in the feature quantity calculated from the physical quantity obtained from the device (70) within the predetermined period. By monitoring the change in the control mode of the motor (50), it is possible to check whether an unintended variation is occurring in the feature quantity. Thus, by releasing the restriction of the estimation process based on the change in the control mode of the motor (50), it is possible to appropriately release the restriction of the estimation process.

A sixth aspect of the present disclosure provides the state estimation device according to the first aspect, in which the motor (50) is driven by AC power generated based on power source power supplied from a power source (60), and the restriction release condition is a condition that an integer multiple or M/N multiple of a rotational frequency of the motor (50) (M and N being integers) is outside a vicinity of an integer multiple of a frequency of a voltage of the power source (60).

In the sixth aspect, the relationship between an integer multiple of the frequency of the voltage of the power source (60) and an integer multiple or M/N multiple of the rotational frequency of the motor (50) correlates with an unintended variation that occurs in the feature quantity calculated from the physical quantity obtained from the device (70) within the predetermined period. By monitoring the relationship between an integer multiple of the frequency of the voltage of the power source (60) and an integer multiple or M/N multiple of the rotational frequency of the motor (50), it is possible to check whether an unintended variation is occurring in the feature quantity. Thus, by releasing the restriction of the estimation process based on the relationship between an integer multiple of the frequency of the voltage of the power source (60) and an integer multiple or M/N multiple of the rotational frequency of the motor (50), it is possible to appropriately release the restriction of the estimation process.

A seventh aspect of the present disclosure provides the state estimation device according to the first aspect, in which the motor (50) is driven by a motor drive device (20) including a DC unit (22) configured to generate DC power corresponding to power source power supplied from a power source (60) and a conversion unit (23) configured to convert the DC power generated by the DC unit (22) into AC power by a switching operation, and the restriction release condition is a condition that a voltage of the DC unit (22) changes from an unsteady state to a steady state.

In the seventh aspect, the state of the voltage of the DC unit (22) correlates with an unintended variation that occurs in the feature quantity calculated from the physical quantity obtained from the device (70) within the predetermined period. By monitoring the state of the voltage of the DC unit (22), it is possible to check whether an unintended variation is occurring in the feature quantity. Thus, by releasing the restriction of the estimation process based on the change in the state of the voltage of the DC unit (22), it is possible to appropriately release the restriction of the estimation process.

An eighth aspect of the present disclosure provides the state estimation device according to the first aspect, in which the device (70) includes a compressor (CC) including the motor (50). The restriction release condition includes at least two of a first release condition that a number of rotations of the motor (50) changes from an unsteady state to a steady state, a second release condition that a pressure of a fluid flowing into the compressor (CC) or a pressure of a fluid flowing out of the compressor (CC) changes from an unsteady state to a steady state, a third release condition that a temperature of the fluid flowing into the compressor (CC) or a temperature of the fluid flowing out of the compressor (CC) changes from an unsteady state to a steady state, a fourth release condition that is a first condition that a control mode of the motor (50) changes after the estimation process is restricted, or a second condition that, when the estimation restriction condition is a condition that the control mode of the motor (50) changes, the estimation process is restricted in accordance with a change in the control mode of the motor (50), a fifth release condition that, in a case where the motor (50) is driven by AC power generated based on power source power supplied from a power source (60), an integer multiple or M/N multiple of a rotational frequency of the motor (50) (M and N being integers) is outside a vicinity of an integer multiple of a frequency of a voltage of the power source (60), and a sixth release condition that, in a case where the motor (50) is driven by a motor drive device (20) including a DC unit (22) configured to generate DC power corresponding to the power source power supplied from the power source (60) and a conversion unit (23) configured to convert the DC power generated by the DC unit (22) into AC power by a switching operation, a voltage of the DC unit (22) changes from an unsteady state to a steady state. The restriction release condition is satisfied when all of conditions included in the restriction release condition are satisfied.

In the eighth aspect, (1) to (6) below correlate with an unintended variation that occurs in the feature quantity calculated from the physical quantity obtained from the device (70) within the predetermined period.

(1) The state of the number of rotations of the motor (50)
(2) The state of the pressure of a fluid flowing into the compressor (CC) or the pressure of a fluid flowing out of the compressor (CC)
(3) The state of the temperature of a fluid flowing into the compressor (CC) or the temperature of a fluid flowing out of the compressor (CC)
(4) The change in the control mode of the motor (50)
(5) The relationship between an integer multiple of the frequency of the voltage of the power source (60) and an integer multiple or M/N multiple of the rotational frequency of the motor (50)
(6) The state of the voltage of the DC unit (22)

By monitoring above (1) to (6), it is possible to check whether an unintended variation is occurring in the feature quantity. Thus, by releasing the restriction of the estimation process based on above (1) to (6), it is possible to appropriately release the restriction of the estimation process.

A ninth aspect of the present disclosure provides the state estimation device according to any one of the first to eighth aspects, in which the physical quantity is any one of a current supplied to the motor (50), a voltage applied to the motor (50), a number of rotations of the motor (50), vibration of the device (70), and sound of the device (70).

A tenth aspect of the present disclosure provides the state estimation device according to any one of the first to ninth aspects, in which the feature quantity is a frequency component.

In the tenth aspect, since the frequency component has a relatively small value, the influence of an unintended variation is likely to be large. Thus, when the feature quantity is a frequency component, it is particularly effective to appropriately restrict the estimation process based on the feature quantity.

An eleventh aspect of the present disclosure provides the state estimation device according to the third or fourth aspect. The estimation restriction condition includes a condition that a number of rotations of the motor (50) is a specific number of rotations and that the pressure of the fluid flowing into the compressor (CC) and the pressure of the fluid flowing out of the compressor (CC) are specific pressures.

A twelfth aspect of the present disclosure relates to a drive system including a motor drive device (20) configured to drive a motor (50) mounted in a device (70), and a state estimation device configured to estimate a state of the device (70). The state estimation device is the state estimation device according to any one of the first to eleventh aspects.

A thirteenth aspect of the present disclosure relates to a refrigeration system including a refrigerant circuit (RR1) including a compressor (CC) including a motor (50), and a state estimation device. The state estimation device is the state estimation device according to any one of the first to eleventh aspects, and is configured to estimate a state of the refrigeration system.

A fourteenth aspect of the present disclosure relates to a fan system including a fan (FF1), a motor (50) configured to drive the fan (FF1), and a state estimation device. The state estimation device is the state estimation device according to any one of the first, second, and fifth to seventh aspects, and is configured to estimate a state of the fan system.

A fifteenth aspect of the present disclosure relates to a state estimation method for estimating a state of a device (70) including a motor (50). The state estimation method includes a calculation step of calculating a feature quantity from a physical quantity obtained from the device (70) within a predetermined period, an estimation step of estimating the state of the device (70), based on the feature quantity calculated in the calculation step, and a restriction step of restricting the estimation step so that a predetermined estimation result is output when a predetermined estimation restriction condition is satisfied, maintaining restriction of the estimation step until a predetermined standby release condition is satisfied when a predetermined restriction release condition is satisfied, and releasing the restriction of the estimation step after the predetermined standby release condition is satisfied. The physical quantity is a quantity that varies in accordance with rotation of the motor (50). The feature quantity is a quantity that varies in accordance with the state of the device (70). The state of the device (70) includes at least one of an abnormality of the motor (50), a degree of deterioration of the motor (50), an abnormality of an element driven by the motor (50), and a degree of deterioration of the element driven by the motor (50). The estimation restriction condition is a condition in which there is a possibility of occurrence of erroneous estimation in the estimation step. The restriction release condition is a condition in which the erroneous estimation in the estimation step is suppressed.

According to the fifteenth aspect, the estimation step is restricted so that a predetermined estimation result is output when a predetermined estimation restriction condition is satisfied. Thus, the erroneous estimation of the state of the device (70) can be appropriately suppressed. In addition, by restricting the estimation step based on the satisfaction of a predetermined restriction release condition, it is possible to appropriately release the restriction of the estimation step.

In the fifteenth aspect, when a predetermined restriction release condition is satisfied, the restriction of the estimation step is maintained until a predetermined standby release condition is satisfied, and, after the predetermined standby release condition is satisfied, the restriction of the estimation step is released. This can release the restriction of the estimation step after stabilizing the feature quantity calculated in the calculation step, compared to a case where the restriction of the estimation step is released without waiting for the predetermined standby release condition to be satisfied. Thus, it is possible to suppress erroneous estimation of the state of the device (70) after the restriction of the estimation step is released.

A sixteenth aspect of the present disclosure provides the state estimation method according to the fifteenth aspect, in which the restriction release condition is a condition that a number of rotations of the motor (50) changes from an unsteady state to a steady state.

In the sixteenth aspect, the state of the number of rotations of the motor (50) correlates with an unintended variation that occurs in the feature quantity calculated from the physical quantity obtained from the device (70) within the predetermined period. By monitoring the state of the number of rotations of the motor (50), it is possible to check whether an unintended variation is occurring in the feature quantity. Thus, by releasing the restriction of the estimation step based on the change in the state of the number of rotations of the motor (50), it is possible to appropriately release the restriction of the estimation step.

A seventeenth aspect of the present disclosure provides the state estimation method according to the fifteenth aspect, in which the device (70) includes a compressor (CC) including the motor (50), and the restriction release condition is a condition that a pressure of a fluid flowing into the compressor (CC) or a pressure of a fluid flowing out of the compressor (CC) changes from an unsteady state to a steady state.

In the seventeenth aspect, the state of the pressure of the fluid flowing into the compressor (CC) or the pressure of the fluid flowing out of the compressor (CC) correlates with an unintended variation that occurs in the feature quantity calculated from the physical quantity obtained from the device (70) within the predetermined period. By monitoring the state of the pressure of the fluid flowing into the compressor (CC) or the pressure of the fluid flowing out of the compressor (CC), it is possible to check whether an unintended variation is occurring in the feature quantity. Thus, by releasing the restriction of the estimation step based on the change in the state of the pressure of the fluid flowing into the compressor (CC) or the pressure of the fluid flowing out of the compressor (CC), it is possible to appropriately release the restriction of the estimation step.

An eighteenth aspect of the present disclosure provides the state estimation method according to the fifteenth aspect, in which the device (70) includes a compressor (CC) including the motor (50), and the restriction release condition is a condition that a temperature of a fluid flowing into the compressor (CC) or a temperature of a fluid flowing out of the compressor (CC) changes from an unsteady state to a steady state.

In the eighteenth aspect, the state of the temperature of the fluid flowing into the compressor (CC) or the temperature of the fluid flowing out of the compressor (CC) correlates with an unintended variation that occurs in the feature quantity calculated from the physical quantity obtained from the device (70) within the predetermined period. By monitoring the state of the temperature of the fluid flowing into the compressor (CC) or the temperature of the fluid flowing out of the compressor (CC), it is possible to check whether an unintended variation is occurring in the feature quantity. Thus, by releasing the restriction of the estimation step based on the change in the state of the temperature of the fluid flowing into the compressor (CC) or the temperature of the fluid flowing out of the compressor (CC), it is possible to appropriately release the restriction of the estimation step.

A nineteenth aspect of the present disclosure provides the state estimation method according to the fifteenth aspect, in which the restriction release condition is a first condition that a control mode of the motor (50) changes after the estimation step is restricted, or a second condition that, when the estimation restriction condition is a condition that the control mode of the motor (50) changes, the estimation step is restricted in accordance with a change in the control mode of the motor (50).

In the nineteenth aspect, the change in the control mode of the motor (50) correlates with an unintended variation that occurs in the feature quantity calculated from the physical quantity obtained from the device (70) within the predetermined period. By monitoring the change in the control mode of the motor (50), it is possible to check whether an unintended variation is occurring in the feature quantity. Thus, by releasing the restriction of the estimation step based on the change in the control mode of the motor (50), it is possible to appropriately release the restriction of the estimation step.

A twentieth aspect of the present disclosure provides the state estimation method according to the fifteenth aspect, in which the motor (50) is driven by AC power generated based on power source power supplied from a power source (60), and the restriction release condition is a condition that an integer multiple or M/N multiple of a rotational frequency of the motor (50) (M and N being integers) is outside a vicinity of an integer multiple of a frequency of a voltage of the power source (60).

In the twentieth aspect, the relationship between an integer multiple of the frequency of the voltage of the power source (60) and an integer multiple or M/N multiple of the rotational frequency of the motor (50) correlates with an unintended variation that occurs in the feature quantity calculated from the physical quantity obtained from the device (70) within the predetermined period. By monitoring the relationship between an integer multiple of the frequency of the voltage of the power source (60) and an integer multiple or M/N multiple of the rotational frequency of the motor (50), it is possible to check whether an unintended variation is occurring in the feature quantity. Thus, by releasing the restriction of the estimation step based on the relationship between an integer multiple of the frequency of the voltage of the power source (60) and an integer multiple or M/N multiple of the rotational frequency of the motor (50), it is possible to appropriately release the restriction of the estimation step.

A twenty-first aspect of the present disclosure provides the state estimation method according to the fifteenth aspect, in which the motor (50) is driven by a motor drive device (20) including a DC unit (22) configured to generate DC power corresponding to power source power supplied from a power source (60) and a conversion unit (23) configured to convert the DC power generated by the DC unit (22) into AC power by a switching operation, and the restriction release condition is a condition that a voltage of the DC unit (22) changes from an unsteady state to a steady state.

In the twenty-first aspect, the state of the voltage of the DC unit (22) correlates with an unintended variation that occurs in the feature quantity calculated from the physical quantity obtained from the device (70) within the predetermined period. By monitoring the state of the voltage of the DC unit (22), it is possible to check whether an unintended variation is occurring in the feature quantity. Thus, by releasing the restriction of the estimation step based on the change in the state of the voltage of the DC unit (22), it is possible to appropriately release the restriction of the estimation step.

A twenty-second aspect of the present disclosure provides the state estimation method according to the fifteenth aspect, in which the device (70) includes a compressor (CC) including the motor (50). The restriction release condition includes at least two of a first release condition that a number of rotations of the motor (50) changes from an unsteady state to a steady state, a second release condition that a pressure of a fluid flowing into the compressor (CC) or a pressure of a fluid flowing out of the compressor (CC) changes from an unsteady state to a steady state, a third release condition that a temperature of the fluid flowing into the compressor (CC) or a temperature of the fluid flowing out of the compressor (CC) changes from an unsteady state to a steady state, a fourth release condition that is a first condition that a control mode of the motor (50) changes after the estimation step is restricted, or a second condition that, when the estimation restriction condition is a condition that the control mode of the motor (50) changes, the estimation step is restricted in accordance with a change in the control mode of the motor (50), a fifth release condition that, in a case where the motor (50) is driven by AC power generated based on power source power supplied from a power source (60), an integer multiple or M/N multiple of a rotational frequency of the motor (50) (M and N being integers) is outside a vicinity of an integer multiple of a frequency of a voltage of the power source (60), and a sixth release condition that, in a case where the motor (50) is driven by a motor drive device (20) including a DC unit (22) configured to generate DC power corresponding to the power source power supplied from the power source (60) and a conversion unit (23) configured to convert the DC power generated by the DC unit (22) into AC power by a switching operation, a voltage of the DC unit (22) changes from an unsteady state to a steady state. The restriction release condition is satisfied when all of conditions included in the restriction release condition are satisfied.

In the twenty-second aspect, (1) to (6) below correlate with an unintended variation that occurs in the feature quantity calculated from the physical quantity obtained from the device (70) within the predetermined period.
(1) The state of the number of rotations of the motor (50)
(2) The state of the pressure of a fluid flowing into the compressor (CC) or the pressure of a fluid flowing out of the compressor (CC)
(3) The state of the temperature of a fluid flowing into the compressor (CC) or the temperature of a fluid flowing out of the compressor (CC)
(4) The change in the control mode of the motor (50)
(5) The relationship between an integer multiple of the frequency of the voltage of the power source (60) and an integer multiple or M/N multiple of the rotational frequency of the motor (50)
(6) The state of the voltage of the DC unit (22)

By monitoring above (1) to (6), it is possible to check whether an unintended variation is occurring in the feature quantity. Thus, by releasing the restriction of the estimation step based on above (1) to (6), it is possible to appropriately release the restriction of the estimation step.
A twenty-third aspect of the present disclosure relates to a state estimation program for causing a computer to execute the state estimation method according to any one of the fifteenth to twenty-second aspects.

Brief Description of Drawings

[Fig. 1] Fig. 1 is a circuit diagram illustrating a configuration of a drive system according to Embodiment 1.

[Fig. 2] Fig. 2 is a flowchart illustrating the flow of processes by a control unit.

[Fig. 3] Fig. 3 is a waveform diagram illustrating a DC signal and an AC signal.

[Fig. 4] Fig. 4 is a graph illustrating first frequency components included in the DC signal.

[Fig. 5] Fig. 5 is a graph illustrating first frequency components included in the AC signal.

[Fig. 6] Fig. 6 is a flowchart illustrating a first estimation process.

[Fig. 7] Fig. 7 is a flowchart illustrating a second estimation process.

[Fig. 8] Fig. 8 is a timing chart illustrating the second estimation process.

[Fig. 9] Fig. 9 is a flowchart illustrating a third estimation process.

[Fig. 10] Fig. 10 is a timing chart illustrating the third estimation process.

[Fig. 11] Fig. 11 is a flowchart illustrating a fourth estimation process.

[Fig. 12] Fig. 12 is a timing chart illustrating the fourth estimation process.

[Fig. 13] Fig. 13 is a schematic diagram illustrating a configuration of a drive system according to Embodiment 5.

[Fig. 14] Fig. 14 is a schematic diagram illustrating a configuration of a refrigeration system.

[Fig. 15] Fig. 15 is a schematic diagram illustrating a configuration of a fan system. Description of Embodiments

Hereinafter, embodiments will be described in detail with reference to the drawings. In the drawings, the same or corresponding parts are denoted by the same reference numerals, and the description thereof will not be repeated.

(Embodiment 1)

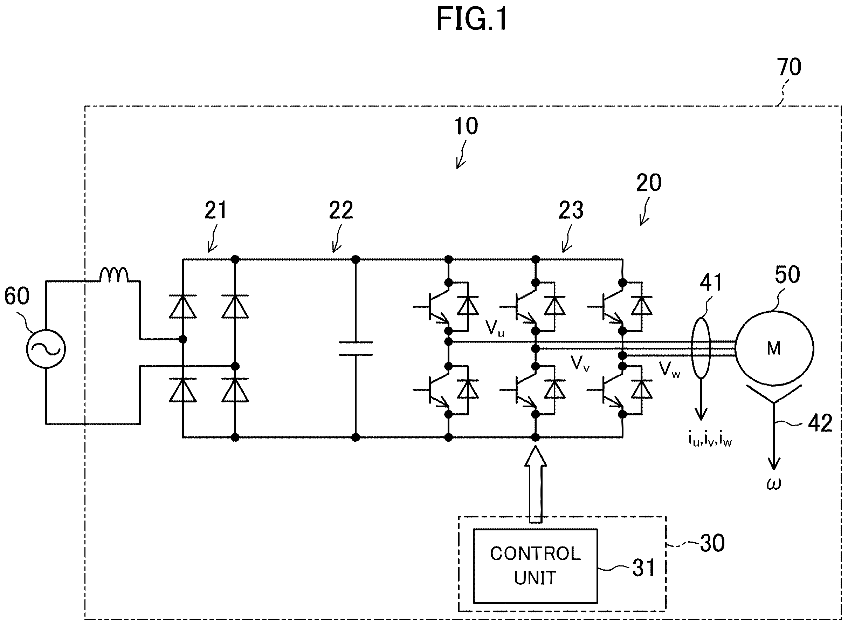

Fig. 1 illustrates a configuration of a drive system (10) according to Embodiment 1. The drive system (10) drives a motor (50) using electric power supplied from a power source (60). The motor (50) is mounted in a device (70). For example, the motor (50) is an IPM motor (Interior Permanent Magnet Motor). In this example, the power source (60) is an AC power source, and the motor (50) is a three-phase AC motor. The drive system (10) is mounted in the device (70). For example, the device (70) is an outdoor unit of an air conditioner. The drive system (10) includes a motor drive device (20) and a control device (30).

[Motor Drive Device]

The motor drive device (20) drives the motor (50). Specifically, the motor drive device (20) converts the electric power supplied from the power source (60) into output AC power (three-phase AC power in this example) having a predetermined frequency and voltage, and supplies the output AC power to the motor (50). In this example, the motor drive device (20) includes a converter (21), a DC unit (22), and an inverter (23).

The converter (21) rectifies the electric power supplied from the power source (60). In this example, the converter (21) performs full-wave rectification on AC power supplied from the power source (60). For example, the converter (21) is constituted by a diode bridge circuit in which a plurality of rectifier diodes are connected in a bridge shape.

The DC unit (22) generates DC power corresponding to power source power supplied from the power source (60). In this example, the DC unit (22) includes a capacitor and smooths an output of the converter (21).

The inverter (23) includes a plurality of switching elements, and converts an output of the DC unit (22) into output AC power (three-phase AC power) having a predetermined frequency and voltage by a switching operation of the plurality of switching elements. The inverter (23) is an example of a conversion unit that converts the DC power generated by the DC unit (22) into AC power by a switching operation.

In this example, the inverter (23) includes six bridge-connected switching elements and six freewheeling diodes respectively connected in anti-parallel to the six switching elements. More specifically, the inverter (23) includes three switching legs each of which includes two switching elements connected in series. Midpoints of the three switching legs (specifically, connection points between the switching elements on the upper arm side and the switching elements on the lower arm side) are respectively connected to three windings (U-phase, V-phase, and W-phase windings) of the motor (50).

[Various Sensors]

The motor drive device (20) is provided with various sensors such as a phase current detection unit (41) and an electrical angular frequency detection unit (42). Various types of information detected by the various sensors are transmitted to the control device (30). Specifically, detection signals of the various sensors are transmitted to a control unit (31) described below.

The phase current detection unit (41) detects three phase currents (a U-phase current (iu), a V-phase current (iv), and a W-phase current (iw)) respectively flowing through the three windings (not illustrated) of the motor (50). For example, the phase current detection unit (41) may detect all of the three phase currents (iu, iv, iw) or may detect two of the three phase currents (iu, iv, iw) and derive the remaining one phase current based on the detected two phase currents. The phase current detection unit (41) may derive the three phase currents (iu, iv, iw) from a DC current detected by a shunt resistance (not illustrated) provided in the DC unit (22) and a switching pattern.

The electrical angular frequency detection unit (42) detects an electrical angular frequency ($\omega$) of the motor (50). The electrical angular frequency detection unit (42) is not an essential component, and the electrical angular frequency ($\omega$) of the motor (50) may be calculated by another method and estimated in a sensorless manner.

[Control Device (State Estimation Device)]

The control device (30) estimates the state of the device (70). The control device (30) is an example of a state estimation device that estimates the state of the device (70) in which the motor (50) is mounted. The process in the control device (30) (the process related to the estimation of the state of the device (70)) is an example of a state estimation method for estimating the state of the device (70) in which the motor (50) is mounted.

In this example, the control device (30) estimates the presence or absence of an abnormality of the device (70) and deals with the abnormality of the device (70). The control device (30) controls the motor (50). Specifically, the control device (30) controls the motor (50) by controlling the motor drive device (20).

[Control Unit]

The control device (30) includes the control unit (31). The control unit (31) performs various processes. Specifically, the control unit (31) acquires information and data from each unit of the device (70), and performs the various processes based on the information and the data. The processes by the control unit (31) will be described in detail below.

For example, the control unit (31) includes a processor and a memory electrically connected to the processor and configured to store a program for operating the processor. The processor executes the program to implement various functions of the control unit (31). The control unit (31) is an example of a computer, and the program described above is an example of a state estimation program.

[Processes by Control Unit]

In this example, the control unit (31) performs a calculation process, an estimation process, a restriction process, a control process, and a countermeasure process. These various processes are examples of various steps. For example, the calculation process is an example of a calculation step, the estimation process is an example of an estimation step, and the restriction process is an example of a restriction step.

[Calculation Process]

In the calculation process, the control unit (31) calculates a feature quantity from a physical quantity obtained from the device (70) within a predetermined period. In this example, the control unit (31) derives a first frequency component of a signal based on the current or voltage of the motor (50). The signal based on the current or voltage of the motor (50) is an example of a physical quantity obtained from the device (70). The first frequency component is an example of a feature quantity. Specific examples of the signal and the first frequency component will be described in detail below.

[Estimation Process]

In the estimation process, the control unit (31) estimates the state of the device (70), based on the feature quantity calculated by the calculation process. Then, the control unit (31) outputs the estimation result. In this example, the control unit (31) estimates the presence or absence of an abnormality of the device (70) in the estimation process. In the estimation process, the control unit (31) estimates the state of the device (70), based on the first frequency component of the signal based on the current or voltage of the motor (50). Specific examples of the estimation process will be described in detail below.

[Restriction Process]

In the restriction process, the control unit (31) restricts the estimation process so that a predetermined estimation result is output when a predetermined estimation restriction condition is satisfied, and releases the restriction of the estimation process after a predetermined standby release condition is satisfied when a predetermined restriction release condition is satisfied. Specific examples of a process for restricting the estimation process will be described in detail below.

In this example (example of estimating the presence or absence of an abnormality of the device (70) in the estimation process), the predetermined estimation result is an estimation result that is not an estimation result indicating that the device (70) is abnormal. Examples of the predetermined estimation result include an estimation result indicating that the device (70) is normal, an estimation result indicating that the state of the device (70) is unknown, an estimation result indicating that the estimation process is prohibited (stopped), and an estimation result output before (e.g., immediately before) the estimation process is restricted.

[Flow of Processes by Control Unit]

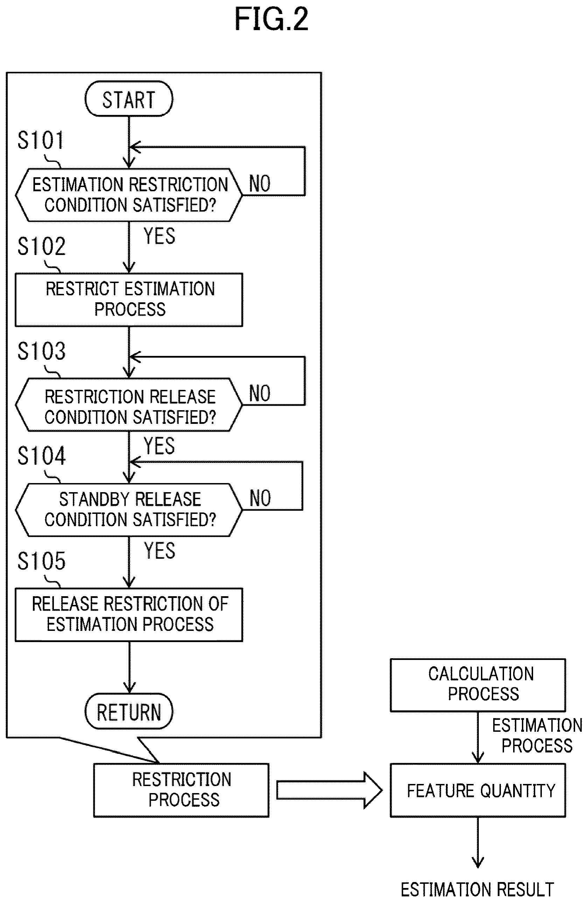

Next, the flow of the processes by the control unit (31) (specifically, the calculation process, the estimation process, and the restriction process) will be described with reference to Fig. 2.

The control unit (31) performs the calculation process for each predetermined calculation time. The calculation process is repeatedly performed, ensuring that the feature quantity is calculated for each calculation time.

Then, the control unit (31) performs the estimation process for each predetermined estimation time, based on the feature quantity calculated by the calculation process. The estimation process is repeatedly performed, ensuring that an estimation result is obtained for each estimation time.

The control unit (31) further performs the restriction process in parallel with the calculation process and the estimation process. Specifically, the control unit (31) repeatedly performs the processing of steps (S101 to S105) illustrated in Fig. 2.

<Step (S101)>

The control unit (31) determines whether the estimation restriction condition is satisfied. If the estimation restriction condition is satisfied, the processing of step (S102) is performed. For example, the processing of step (S101) is performed for each predetermined determination time. In other words, the processing of step (S101) is repeatedly performed until the estimation restriction condition is satisfied.

<Step (S102)>

If the estimation restriction condition is satisfied, the control unit (31) restricts the estimation process so that a predetermined estimation result is output.

<Step (S103)>

Subsequently, the control unit (31) determines whether the restriction release condition is satisfied. If the restriction release condition is satisfied, the processing of step (S104) is performed. For example, the processing of step (S103) is performed for each predetermined determination time. In other words, the processing of step (S103) is repeatedly performed until the restriction release condition is satisfied.

<Step (S104)>

Subsequently, the control unit (31) determines whether the standby release condition is satisfied. If the standby release condition is satisfied, the processing of step (S105) is performed. For example, the processing of step (S104) is performed for each predetermined determination time. In other words, the processing of step (S104) is repeatedly performed until the standby release condition is satisfied.

<Step (S105)>

If the standby release condition is satisfied after the restriction release condition is satisfied, the control unit (31) releases the restriction of the estimation process.

[Control Process]

In the control process, the control unit (31) controls the motor drive device (20) to control the motor (50). Specifically, the control unit (31) receives a target command value such as a command value of the electrical angular frequency ($\omega$) of the motor (50), detection signals of the various sensors provided in the motor drive device (20), and the like. Then, the control unit (31) controls the switching operation of the inverter (23) based on the target command value, the detection signals of the various sensors, and the like to control the AC power to be supplied from the inverter (23) to the motor (50).

[Countermeasure Process]

In this example, the control unit (31) performs the countermeasure process when estimating that the state of the device (70) is an "abnormal state" in the estimation process. The countermeasure process is a process for dealing with the abnormality of the device (70), and includes at least one of an output process for outputting first information indicating that the state of the device (70) is the abnormal state, and a change process for changing an operation condition of the motor (50).

Examples of the output process include the following first output process, second output process, and third output process, and a combination thereof. The first output process is a process for outputting the first information to a display device (not illustrated) provided in a remote controller or the like to cause the display device to display the first information. The second output process is a process for outputting the first information to a control unit (not illustrated) that controls the operation of the device (70) to cause the control unit to perform an operation for dealing with the abnormal state. The third output process is a process for uploading the first information to a data accumulation unit (not illustrated) on the cloud.

Examples of the change process include the following first change process, second change process, and third change process, and a combination thereof. The first change process is a process for stopping the motor (50). The second change process is a process for accelerating the motor (50). The third change process is a process for decelerating the motor (50).

[Estimation Restriction Condition and Restriction Release Condition]

The estimation restriction condition according to Embodiment 1 is a condition that the number of rotations of the motor (50) changes from a steady state to an unsteady state. The restriction release condition according to Embodiment 1 is a condition that the number of rotations of the motor (50) changes from the unsteady state to the steady state. In the restriction process according to Embodiment 1, the control unit (31) restricts the estimation process so that a predetermined estimation result is output when the number of rotations of the motor (50) changes from the steady state to the unsteady state, and releases the restriction of the estimation process after a predetermined standby release condition is satisfied when the number of rotations of the motor (50) changes from the unsteady state to the steady state.

The number of rotations of the motor (50) may be detected by, for example, a number-of-rotations detection unit (not illustrated) provided in the drive system (10). The number of rotations of the motor (50) detected by the number-of-rotations detection unit is transmitted to the control unit (31).

The steady state of the number of rotations of the motor (50) is, for example, a state in which the difference between a command value of the number of rotations and a measured value of the number of rotations is within a predetermined difference. For example, the predetermined difference is 0.1 rps. The unsteady state of the number of rotations of the motor (50) is a state in which the difference between the command value of the number of rotations and the measured value of the number of rotations is greater than the predetermined difference.

Alternatively, the steady state of the number of rotations of the motor (50) may be a state in which the difference between the current and previous measured values of the number of rotations is within a predetermined difference. For example, the previous value is a measured value of the number of rotations acquired one second before the current value, and the predetermined difference is 0.1 rps. The unsteady state of the number of rotations of the motor (50) may be a state in which the difference between the current and previous measured values of the number of rotations is greater than the predetermined difference.

Instead of the measured value of the number of rotations described above, the command value of the number of rotations may be used. For example, the steady state of the number of rotations of the motor (50) may be a state in which the difference between the current and previous command values of the number of rotations is within a predetermined difference.

Alternatively, the steady state of the number of rotations of the motor (50) may be a state in which neither an acceleration flag nor a deceleration flag of the number of rotations held in the control unit (31) is set. The control unit (31) may set the acceleration flag of the number of rotations held in the control unit (31) to increase the number of rotations of the motor (50), and may clear the acceleration flag otherwise. Further, the control unit (31) may set the deceleration flag of the number of rotations held in the control unit (31) to decrease the number of rotations of the motor (50), and may clear the deceleration flag otherwise. The unsteady state of the number of rotations of the motor (50) may be a state in which one of the acceleration flag and the deceleration flag of the number of rotations held in the control unit (31) is set.

[Effects of Embodiment 1]

As described above, in Embodiment 1, in the restriction process, the control unit (31) restricts the estimation process so that a predetermined estimation result is output when a predetermined estimation restriction condition is satisfied, and releases the restriction of the estimation process after a predetermined standby release condition is satisfied when a predetermined restriction release condition is satisfied.

In the above configuration, the estimation process is restricted so that a predetermined estimation result is output when an estimation restriction condition (e.g., a condition in which an unintended variation occurs in the feature quantity) is satisfied, thereby enabling suppression of the erroneous estimation of the state of the device (70). In this example, it is possible to restrict the estimation process so that an estimation result indicating that the device (70) is abnormal is not output. Thus, it is possible to prevent the erroneous estimation that the device (70) is abnormal.

In Embodiment 1, the estimation restriction condition is a condition that the number of rotations of the motor (50) changes from the steady state to the unsteady state. The restriction release condition is a condition that the number of rotations of the motor (50) changes from the unsteady state to the steady state.

In Embodiment 1, the state of the number of rotations of the motor (50) correlates with an unintended variation that occurs in the feature quantity calculated from the physical quantity obtained from the device (70) within the predetermined period. For example, when the number of rotations of the motor (50) is in the steady state, an unintended variation tends to be unlikely to occur in the feature quantity, and when the number of rotations of the motor (50) is in the unsteady state, an unintended variation tends to be likely to occur in the feature quantity. By monitoring the state of the number of rotations of the motor (50), it is possible to check whether an unintended variation is occurring in the feature quantity. Thus, by restricting the estimation process and releasing the restriction of the estimation process based on the change in the state of the number of rotations of the motor (50), it is possible to appropriately restrict the estimation process and release the restriction of the estimation process.

In Embodiment 1, the feature quantity is a frequency component. Since the frequency component has a relatively small value, the influence of an unintended variation is likely to be large. Thus, when the feature quantity is a frequency component, it is particularly effective to appropriately restrict the estimation process based on the feature quantity.

Immediately after the predetermined restriction release condition is satisfied, the influence of an unintended variation is likely to remain in the feature quantity (particularly, the frequency component) calculated from the physical quantity obtained from the device (70) within the predetermined period. Thus, if the restriction of the estimation process is released after the restriction release condition is satisfied without waiting for the standby release condition to be satisfied, the state of the device (70) may be erroneously estimated in the estimation process after the restriction is released.

In Embodiment 1, accordingly, in the restriction process, when a predetermined restriction release condition is satisfied, the control unit (31) releases the restriction of the estimation process after a predetermined standby release condition is satisfied. This configuration can release the restriction of the estimation process after stabilizing the feature quantity calculated by the calculation process, compared to a case where the restriction of the estimation process is released after the restriction release condition is satisfied without waiting for the standby release condition to be satisfied. Thus, it is possible to suppress erroneous estimation of the state of the device (70) after the restriction of the estimation process is released.

(Comparison between Embodiment and Comparative Example)

One possible example of the estimation restriction condition is a condition (comparative example) that the state of the power source (60) changes from normal to abnormal. One possible example of the restriction release condition is a condition (comparative example) that the state of the power source (60) changes from abnormal to normal. However, the feature quantity calculated from the physical quantity obtained from the device (70) within the predetermined period may vary unintentionally due to factors other than the power source (60). Thus, restricting the estimation process and releasing the restriction of the estimation process based on only the state of the power source (60) is insufficient to suppress erroneous estimation of the state of the device (70).

(Specific Examples of Signal)

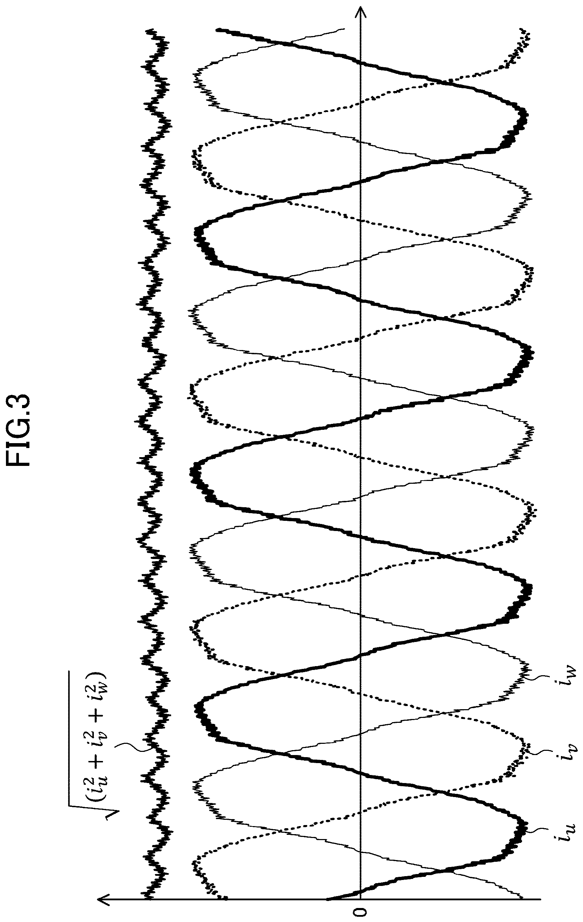

Next, specific examples of the "signal based on the current or voltage of the motor (50)" will be described. This signal is roughly classified into a DC signal and an AC signal. Fig. 3 illustrates the DC signal and the AC signal. Fig. 3 illustrates the "square root of the sum of the square values of the phase currents (iu, iv, iw) of the motor (50)" as an example of the DC signal, and the "phase currents (iu, iv, iw) of the motor (50)" as an example of the AC signal.

[Specific Examples of DC Signal]

Examples of the DC signal include a "signal correlated with the phase currents (iu, iv, iw) of the motor (50)", a "signal correlated with phase voltages (Vu, Vv, Vw) of the motor (50)", and a "signal correlated with electric power of the motor (50)".

Other examples of the DC signal include "currents ($i\gamma$, $i\delta$) obtained by coordinate transformation of the phase currents (iu, iv, iw) of the motor (50) by a phase ($\omega i \cdot t$) of the phase currents (iu, iv, iw) of the motor (50)", "voltages ($V\gamma$, $V\delta$) obtained by coordinate transformation of the phase voltages (Vu, Vv, Vw) of the motor (50) by a phase ($\omega v \cdot t$) of the phase voltages (Vu, Vv, Vw) of the motor (50)", "currents ($i\zeta$, $i\eta$) obtained by coordinate transformation of the phase currents (iu, iv, iw) of the motor (50) by the phase ($\omega v \cdot t$) of the phase voltages (Vu, Vv, Vw) of the motor (50)", and "voltages ($V\zeta$, $V\eta$) obtained by coordinate transformation of the phase voltages (Vu, Vv, Vw) of the motor (50) by the phase ($\omega i \cdot t$) of the phase currents (iu, iv, iw) of the motor (50)".

Still other examples of the DC signal include "dq-axis magnetic fluxes ($\lambda d$, $\lambda q$) obtained by coordinate transformation in accordance with an armature interlinkage magnetic flux by a permanent magnet" and a "magnitude $\lambda 0$ of an armature interlinkage magnetic flux vector obtained by combining the armature interlinkage magnetic flux of the permanent magnet and the armature reaction".

In the following description, the "phase currents (iu, iv, iw) of the motor (50)" refer to the phase currents (iu, iv, iw) of the motor (50) detected by the phase current detection unit (41). The "phase voltages (Vu, Vv, Vw) of the motor (50)" refer to the phase voltages (Vu, Vv, Vw) of the motor (50) indicated by a voltage command value used inside the control unit (31), or the phase voltages (Vu, Vv, Vw) of the motor (50) detected by a phase voltage detection unit (not illustrated) provided in the motor drive device (20). The "electrical angular frequency ($\omega$) of the motor (50)" refers to the electrical angular frequency ($\omega$) of the motor (50) detected by the electrical angular frequency detection unit (42).

[1. Specific Examples of Signal Correlated with Phase Currents of Motor]

Specific examples of the signal correlated with the phase currents (iu, iv, iw) of the motor (50) include a current vector amplitude (Ia), a square value of the current vector amplitude (Ia$^2$), a phase current amplitude (I), and a phase current effective value (Irms).

The current vector amplitude (Ia) and the square value of the current vector amplitude (Ia$^2$) are examples of a value corresponding to the sum of the square values of the three phase currents (iu, iv, iw) of the motor (50). The value corresponding to the sum of the square values of the three phase currents (iu, iv, iw) of the motor (50) is an example of a value proportional to an integer power of the magnitude of the phase currents (iu, iv, iw) of the motor (50).

(1) Current Vector Amplitude

The current vector amplitude (Ia) is derived based on the phase currents (iu, iv, iw) of the motor (50). Alternatively, the current vector amplitude (Ia) may be derived based on an α-phase current (iα) and a β-phase current (iβ) obtained by transforming the phase currents (iu, iv, iw) of the motor (50) into a fixed coordinate system. Alternatively, the current vector amplitude (Ia) may be derived based on an M-axis current (iM) and a T-axis current (iT) obtained by coordinate transformation of the phase currents (iu, iv, iw) of the motor (50) by an angle based on the direction of a primary magnetic flux. Alternatively, the current vector amplitude (Ia) may be derived based on a d-axis current (id) and a q-axis current (iq) obtained by coordinate transformation of the phase currents (iu, iv, iw) of the motor (50) by an angle based on the direction of a magnetic pole position. Specifically, the current vector amplitude (Ia) can be expressed by the following equation.

[Math. 1]

$$I_a = \sqrt{i_u^2 + i_v^2 + i_w^2} = \sqrt{i_\alpha^2 + i_\beta^2} = \sqrt{i_M^2 + i_T^2} = \sqrt{i_d^2 + i_q^2}$$

(2) Square Value of Current Vector Amplitude

The square value of the current vector amplitude (Ia$^2$) is derived based on the phase currents (iu, iv, iw) of the motor (50). Alternatively, the square value of the current vector amplitude (Ia$^2$) may be derived based on an α-phase current (iα) and a β-phase current (iβ) obtained by transforming the phase currents (iu, iv, iw) of the motor (50) into a fixed coordinate system. Alternatively, the square value of the current vector amplitude (Ia$^2$) may be derived based on an M-axis current (iM) and a T-axis current (iT) obtained by coordinate transformation of the phase currents (iu, iv, iw) of the motor (50) by an angle based on the direction of a primary magnetic flux. Alternatively, the square value of the current vector amplitude (Ia$^2$) may be derived based on a d-axis current (id) and a q-axis current (iq) obtained by coordinate transformation of the phase currents (iu, iv, iw) of the motor (50) by an angle based on the direction of a magnetic pole position. Specifically, the square value of the current vector amplitude (Ia$^2$) can be expressed by the following equation.

[Math. 2]

$$I_a^2 = i_u^2 + i_v^2 + i_w^2 = i_\alpha^2 + i_\beta^2 = i_M^2 + i_T^2 = i_d^2 + i_q^2$$

(3) Phase Current Amplitude

The phase current amplitude (I) is derived based on one phase current (e.g., the U-phase current (iu)) among the phase currents (iu, iv, iw) of the motor (50) and a phase (ωi) of the phase current. The phase (ωi) of the phase current is derived based on, for example, the phase currents (iu, iv, iw) of the motor (50). Specifically, the phase current amplitude (I) can be expressed by the following equation.

[Math. 3]

$$I = \frac{i_u}{\cos \omega_i t}$$

(4) Phase Current Effective Value

The phase current effective value (Irms) is derived based on the phase current amplitude (I). Specifically, the phase current effective value (Irms) can be expressed by the following equation.

[Math. 4]

$$I_{rms} = \frac{I}{\sqrt{2}}$$

(5) Others

In the above description, a case where the current vector amplitude (Ia) is derived based on the three phase currents (iu, iv, iw) of the motor (50) has been described as an example. However, the current vector amplitude (Ia) may be derived based on two phase currents of the three phase currents (iu, iv, iw) of the motor (50). Alternatively, the current vector amplitude (Ia) may be derived based on the DC current of the inverter (23) detected by a DC current detection unit (e.g., a shunt resistance, not illustrated) provided in the motor drive device (20). The same applies to the square value of the current vector amplitude ($Ia^2$).

[2. Specific Examples of Signal Correlated with Phase Voltages of Motor]

Specific examples of the signal correlated with the phase voltages (Vu, Vv, Vw) of the motor (50) include a voltage vector amplitude (Va), a square value of the voltage vector amplitude ($Va^2$), a phase voltage amplitude (V), and a phase voltage effective value (Vrms).
The voltage vector amplitude (Va) and the square value of the voltage vector amplitude ($Va^2$) are examples of a value corresponding to the sum of the square values of the three phase voltages (Vu, Vv, Vw) of the motor (50). The value corresponding to the sum of the square values of the three phase voltages (Vu, Vv, Vw) of the motor (50) is an example of a value proportional to an integer power of the magnitude of the phase voltages (Vu, Vv, Vw) of the motor (50).

(1) Voltage Vector Amplitude

The voltage vector amplitude (Va) is derived based on the phase voltages (Vu, Vv, Vw) of the motor (50). Alternatively, the voltage vector amplitude (Va) may be derived based on an $\alpha$-phase voltage (V$\alpha$) and a $\beta$-phase voltage (V$\beta$) obtained by transforming the phase voltages (Vu, Vv, Vw) of the motor (50) into a fixed coordinate system. Alternatively, the voltage vector amplitude (Va) may be derived based on an M-axis voltage (VM) and a T-axis voltage (VT) obtained by coordinate transformation of the phase voltages (Vu, Vv, Vw) of the motor (50) by an angle based on the direction of a primary magnetic flux. Alternatively, the voltage vector amplitude (Va) may be derived based on a d-axis voltage (Vd) and a q-axis voltage (Vq) obtained by coordinate transformation of the phase voltages (Vu, Vv, Vw) of the motor (50) by an angle based on the direction of a magnetic pole position. Specifically, the voltage vector amplitude (Va) can be expressed by the following equation.

[Math. 5]

$$V_a = \sqrt{v_u^2 + v_v^2 + v_w^2} = \sqrt{v_\alpha^2 + v_\beta^2} = \sqrt{v_M^2 + v_T^2} = \sqrt{v_d^2 + v_q^2}$$

(2) Square Value of Voltage Vector Amplitude

The square value of the voltage vector amplitude ($Va^2$) is derived based on the phase voltages (Vu, Vv, Vw) of the motor (50). Alternatively, the square value of the voltage vector amplitude ($Va^2$) may be derived based on an $\alpha$-phase voltage (V$\alpha$) and a $\beta$-phase voltage (V$\beta$) obtained by transforming the phase voltages (Vu, Vv, Vw) of the motor (50) into a fixed coordinate system. Alternatively, the square value of the voltage vector amplitude ($Va^2$) may be derived based on an M-axis voltage (VM) and a T-axis voltage (VT) obtained by coordinate transformation of the phase voltages (Vu, Vv, Vw) of the motor (50) by an angle based on the direction of a primary magnetic flux. Alternatively, the square value of the voltage vector amplitude ($Va^2$) may be derived based on a d-axis voltage (Vd) and a q-axis voltage (Vq) obtained by coordinate transformation of the phase voltages (Vu, Vv, Vw) of the motor (50) by an angle based on the direction of a magnetic pole position. Specifically, the square value of the voltage vector amplitude (Va2) can be expressed by the following equation.

[Math. 6]

$$V_a^2 = v_u^2 + v_v^2 + v_w^2 = v_\alpha^2 + v_\beta^2 = v_M^2 + v_T^2 = v_d^2 + v_q^2$$

(3) Phase Voltage Amplitude

The phase voltage amplitude (V) is derived based on one phase voltage (e.g., the U-phase voltage (Vu)) among the phase voltages (Vu, Vv, Vw) of the motor (50) and a phase (ωv) of the phase voltage. The phase (ωv) of the phase voltage is derived based on, for example, the phase voltages (Vu, Vv, Vw) of the motor (50). Specifically, the phase voltage amplitude (V) can be expressed by the following equation.

[Math. 7]

$$V = \frac{v_u}{\cos \omega_v t}$$

(4) Phase Voltage Effective Value

The phase voltage effective value (Vrms) is derived based on the phase voltage amplitude (V). Specifically, the phase voltage effective value (Vrms) can be expressed by the following equation.

[Math. 8]

$$V_{rms} = \frac{V}{\sqrt{2}}$$

(5) Others

In the above description, a case where the voltage vector amplitude (Va) is derived based on the three phase voltages (Vu, Vv, Vw) of the motor (50) has been described as an example. However, the voltage vector amplitude (Va) may be derived based on two phase voltages of the three phase voltages (Vu, Vv, Vw) of the motor (50). The same applies to the square value of the voltage vector amplitude (Va2).

[3. Specific Examples of Signal Correlated with Electric Power of Motor]

Examples of the signal correlated with the electric power of the motor (50) include instantaneous power (p), instantaneous imaginary power (q), apparent power (S), active power (P), and reactive power (Q).

(1) Instantaneous Power

The instantaneous power (p) is derived based on the phase currents (iu, iv, iw) of the motor (50) and the phase voltages (Vu, Vv, Vw) of the motor (50). Alternatively, the instantaneous power (p) may be derived based on an α-phase current (iα) and a β-phase current (iβ) obtained by transforming the phase currents (iu, iv, iw) of the motor (50) into a fixed coordinate system, and an α-phase voltage (Vα) and a β-phase voltage (Vβ) obtained by transforming the phase voltages (Vu, Vv, Vw) of the motor (50) into a fixed coordinate system. Alternatively, the instantaneous power (p) may be derived based on an M-axis current (iM) and a T-axis current (iT) obtained by coordinate transformation of the phase currents (iu, iv, iw) of the motor (50) by an angle based on the direction of a primary magnetic flux, and an M-axis voltage (VM) and a T-axis voltage (VT) obtained by coordinate transformation of the phase voltages (Vu, Vv, Vw) of the motor (50) by an angle based on the direction of a primary magnetic flux. Alternatively, the instantaneous power (p) may be derived based on a d-axis current (id) and a q-axis current (iq) obtained by coordinate transformation of the phase currents (iu, iv, iw) of the motor (50) by an angle based on the direction of a magnetic pole position, and a d-axis voltage (Vd) and a q-axis voltage (Vq) obtained by coordinate transformation of the phase voltages (Vu, Vv, Vw) of the motor (50) by an angle based on the direction of a magnetic pole position. Specifically, the instantaneous power (p) can be expressed by the following equation.

[Math. 9]

$$p = v_u i_u + v_v i_v + v_w i_w = v_\alpha i_\alpha + v_\beta i_\beta = v_M i_M + v_T i_T = v_d i_d + v_q i_q$$

(2) Instantaneous Imaginary Power

The instantaneous imaginary power (q) is derived based on an $\alpha$-phase current (i$\alpha$) and a $\beta$-phase current (i$\beta$) obtained by transforming the phase currents (iu, iv, iw) of the motor (50) into a fixed coordinate system, and an $\alpha$-phase voltage (V$\alpha$) and a $\beta$-phase voltage (V$\beta$) obtained by transforming the phase voltages (Vu, Vv, Vw) of the motor (50) into a fixed coordinate system. Alternatively, the instantaneous imaginary power (q) may be derived based on an M-axis current (iM) and a T-axis current (iT) obtained by coordinate transformation of the phase currents (iu, iv, iw) of the motor (50) by an angle based on the direction of a primary magnetic flux, and an M-axis voltage (VM) and a T-axis voltage (VT) obtained by coordinate transformation of the phase voltages (Vu, Vv, Vw) of the motor (50) by an angle based on the direction of a primary magnetic flux. Alternatively, the instantaneous imaginary power (q) may be derived based on a d-axis current (id) and a q-axis current (iq) obtained by coordinate transformation of the phase currents (iu, iv, iw) of the motor (50) by an angle based on the direction of a magnetic pole position, and a d-axis voltage (Vd) and a q-axis voltage (Vq) obtained by coordinate transformation of the phase voltages (Vu, Vv, Vw) of the motor (50) by an angle based on the direction of a magnetic pole position. Specifically, the instantaneous imaginary power (q) can be expressed by the following equation.

[Math. 10]

$$q = v_\alpha i_\beta - v_\beta i_\alpha = v_M i_T - v_T i_M = v_d i_q - v_q i_d$$

(3) Apparent Power

The apparent power (S) is derived based on the phase voltage effective value (Vrms) and the phase current effective value (Irms). Specifically, the apparent power (S) can be expressed by the following equation.

[Math. 11]

$$S = 3V_{rms}I_{rms}$$

(4) Active Power

The active power (P) is derived based on the phase voltage effective value (Vrms), the phase current effective value (Irms), and a phase difference ($\varphi$1) between a phase voltage and a phase current. The phase difference ($\varphi$1) between a phase voltage and a phase current is a phase difference between one phase voltage (e.g., the U-phase voltage (Vu)) and one phase current (e.g., the U-phase current (iu)), and is derived based on the phase ($\omega$i) of the phase current and the phase ($\omega$v) of the phase voltage. Specifically, the active power (P) can be expressed by the following equation.

[Math. 12]

$$P = 3V_{rms}I_{rms}\cos\varphi_1$$

(5) Reactive Power

The reactive power (Q) is derived based on the phase voltage effective value (Vrms), the phase current effective value (Irms), and a phase difference ($\varphi$1) between a phase voltage and a phase current. The phase difference ($\varphi$1) between a phase voltage and a phase current is, for example, a phase difference between the U-phase voltage (Vu) and the U-phase current (iu), and is derived based on the phase ($\omega$i) of the phase current and the phase ($\omega$v) of the phase voltage. Specifically, the reactive power (Q) can be expressed by the following equation.

[Math. 13]

$$Q = -3V_{rms}I_{rms} \sin \varphi_1$$

[4. Currents Obtained by Coordinate Transformation of Phase Currents by Phase of Phase Currents]

The currents ($i_\gamma$, $i_\delta$) obtained by coordinate transformation of the phase currents ($i_u$, $i_v$, $i_w$) of the motor (50) by the phase ($\omega_i \cdot t$) of the phase currents ($i_u$, $i_v$, $i_w$) of the motor (50) can be expressed by the following equation.

[Math. 14]

$$\begin{bmatrix} i_\gamma \\ i_\delta \end{bmatrix} = k \begin{bmatrix} \cos \omega_i t & \cos \left( \omega_i t - \frac{2}{3}\pi \right) & \cos \left( \omega_i t - \frac{4}{3}\pi \right) \\ -\sin \omega_i t & -\sin \left( \omega_i t - \frac{2}{3}\pi \right) & -\sin \left( \omega_i t - \frac{4}{3}\pi \right) \end{bmatrix} \begin{bmatrix} i_u \\ i_v \\ i_w \end{bmatrix}$$

[5. Voltages Obtained by Coordinate Transformation of Phase Voltages by Phase of Phase Voltages]

The voltages ($V_\gamma$, $V_\delta$) obtained by coordinate transformation of the phase voltages ($V_u$, $V_v$, $V_w$) of the motor (50) by the phase ($\omega_v \cdot t$) of the phase voltages ($V_u$, $V_v$, $V_w$) of the motor (50) can be expressed by the following equation.

[Math. 15]

$$\begin{bmatrix} v_\gamma \\ v_\delta \end{bmatrix} = k \begin{bmatrix} \cos \omega_v t & \cos \left( \omega_v t - \frac{2}{3}\pi \right) & \cos \left( \omega_v t - \frac{4}{3}\pi \right) \\ -\sin \omega_v t & -\sin \left( \omega_v t - \frac{2}{3}\pi \right) & -\sin \left( \omega_v t - \frac{4}{3}\pi \right) \end{bmatrix} \begin{bmatrix} v_u \\ v_v \\ v_w \end{bmatrix}$$

[6. Currents Obtained by Coordinate Transformation of Phase Currents by Phase of Phase Voltages]

The currents ($i_\zeta$, $i_\eta$) obtained by coordinate transformation of the phase currents ($i_u$, $i_v$, $i_w$) of the motor (50) by the phase ($\omega_v \cdot t$) of the phase voltages ($V_u$, $V_v$, $V_w$) of the motor (50) can be expressed by the following equation.

[Math. 16]

$$\begin{bmatrix} i_\zeta \\ i_\eta \end{bmatrix} = k \begin{bmatrix} \cos \omega_v t & \cos \left( \omega_v t - \frac{2}{3}\pi \right) & \cos \left( \omega_v t - \frac{4}{3}\pi \right) \\ -\sin \omega_v t & -\sin \left( \omega_v t - \frac{2}{3}\pi \right) & -\sin \left( \omega_v t - \frac{4}{3}\pi \right) \end{bmatrix} \begin{bmatrix} i_u \\ i_v \\ i_w \end{bmatrix}$$

[7. Voltages Obtained by Coordinate Transformation of Phase Voltages by Phase of Phase Currents]

The voltages ($V_\zeta$, $V_\eta$) obtained by coordinate transformation of the phase voltages ($V_u$, $V_v$, $V_w$) of the motor (50) by the phase ($\omega_i \cdot t$) of the phase currents ($i_u$, $i_v$, $i_w$) of the motor (50) can be expressed by the following equation.

[Math. 17]

$$\begin{bmatrix} v_\zeta \\ v_\eta \end{bmatrix} = k \begin{bmatrix} \cos \omega_i t & \cos\left(\omega_i t - \dfrac{2}{3}\pi\right) & \cos\left(\omega_i t - \dfrac{4}{3}\pi\right) \\ -\sin \omega_i t & -\sin\left(\omega_i t - \dfrac{2}{3}\pi\right) & -\sin\left(\omega_i t - \dfrac{4}{3}\pi\right) \end{bmatrix} \begin{bmatrix} v_u \\ v_v \\ v_w \end{bmatrix}$$

[8. dq-Axis Magnetic Fluxes and Magnitude of Armature Interlinkage Magnetic Flux Vector]

The dq-axis magnetic fluxes (λd, λq) obtained by coordinate transformation in accordance with an armature interlinkage magnetic flux by a permanent magnet and the magnitude λ0 of an armature interlinkage magnetic flux vector obtained by combining the armature interlinkage magnetic flux of the permanent magnet and the armature reaction can be expressed by the following equations. In the following equations, "Ld" is a d-axis inductance and "Lq" is a q-axis inductance.

[Math. 18]

$$\begin{bmatrix} \lambda_d \\ \lambda_q \end{bmatrix} = \begin{bmatrix} L_d & 0 \\ 0 & L_q \end{bmatrix} \begin{bmatrix} i_d \\ i_q \end{bmatrix} + \begin{bmatrix} \Lambda_a \\ 0 \end{bmatrix}$$

$$\lambda_0 = \sqrt{\lambda_d^2 + \lambda_q^2}$$

[9. Other Examples of DC Signal]

The DC signal may be a DC signal obtained by performing three-phase to two-phase transformation on a phase current, a phase voltage, a line current, or a line voltage of the motor (50) and further performing rotational coordinate transformation thereon. For example, the DC signal may be a d-axis current and a q-axis current obtained by performing rotational coordinate transformation on an α-axis current and a β-axis current, which are obtained by three-phase to two-phase transformation of the phase current of the motor (50), at an angle based on the direction of a magnetic pole of a rotor of the motor (50). Alternatively, the DC signal may be an M-axis current and a T-axis current obtained by performing rotational coordinate transformation on an α-axis current and a β-axis current at an angle based on the direction of a primary magnetic flux of the rotor of the motor (50).

The DC signal may be electric power input to the converter (21) of the motor drive device (20), electric power output from the converter (21), electric power output from the DC unit (22), a current flowing between the converter (21) and the DC unit (22), a current flowing between the DC unit (22) and the inverter (23), or the like.

[Specific Examples of AC Signal]

Examples of the AC signal include the "phase currents (iu, iv, iw) of the motor (50)", the "phase voltages (Vu, Vv, Vw) of the motor (50)", and "interlinkage magnetic fluxes (Ψfu, Ψfv, Ψfw) of the respective phases".

The interlinkage magnetic fluxes (Ψfu, Ψfv, Ψfw) of the respective phases can be expressed by the following expressions.

[Math. 19]

$$\psi_{fu} = \frac{\sqrt{2}}{3}\lambda_0 \cos\theta$$

$$\psi_{fv} = \frac{\sqrt{2}}{3}\lambda_0 \cos\left(\theta - \frac{2}{3}\pi\right)$$

$$\psi_{fw} = \frac{\sqrt{2}}{3}\lambda_0 \cos\left(\theta + \frac{2}{3}\pi\right)$$

Other examples of the AC signal include a current, a voltage, and an interlinkage magnetic flux of fixed coordinates obtained by three-phase to two-phase transformation of the AC signal described above.

Alternatively, the AC signal may be a line current, a line voltage, or the like of the motor (50). Alternatively, the AC signal may be a two-phase AC current (e.g., an $\alpha$-axis current and a $\beta$-axis current) or a two-phase AC voltage obtained by three-phase to two-phase transformation of a phase current, a phase voltage, a line current, or a line voltage. The AC current may be a current flowing between a commercial power source system (specifically, the AC power source (60)) and the converter (21) of the motor drive device (20).

(Specific Examples of First Frequency Component)

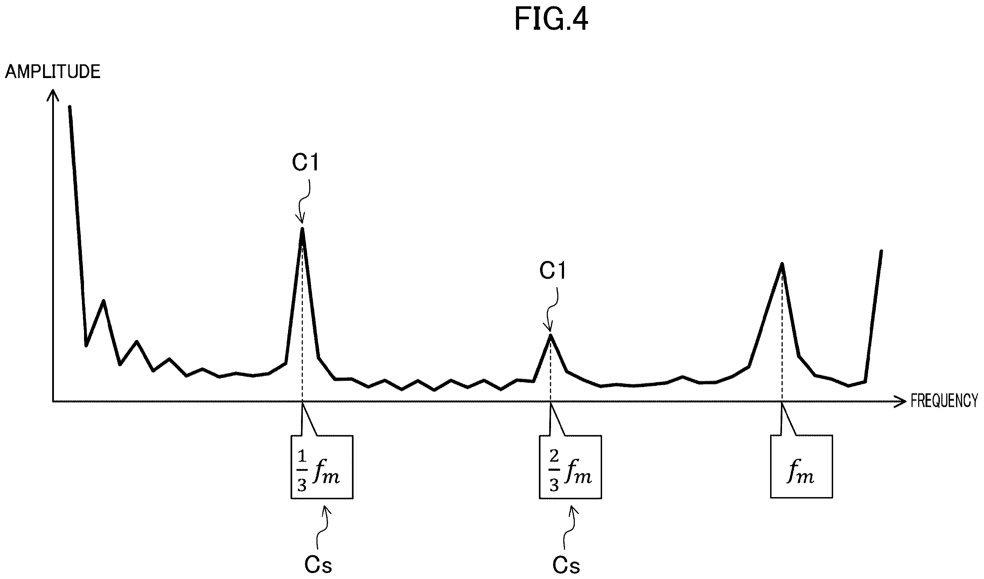

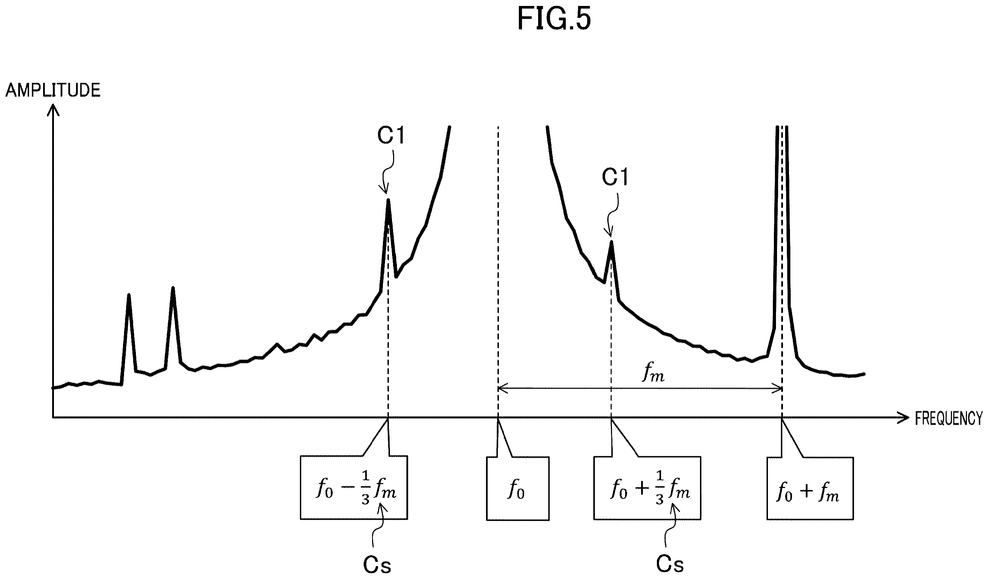

Next, a first frequency component (C1) of the signal based on the current or voltage of the motor (50) will be described with reference to Figs. 4 and 5.

As illustrated in Fig. 4, when the signal described above is a DC signal, the frequency of the first frequency component (C1) is the frequency of a specific frequency component (Cs).

The specific frequency component (Cs) is a frequency component less than 1 time a mechanical angular frequency (fm) of the motor (50). The frequency of the specific frequency component (Cs) is a frequency obtained by multiplying the mechanical angular frequency (fm) of the motor (50) by a specific ratio. The specific ratio is a fractional ratio represented by the reciprocal of a natural number. For example, the specific ratio is 1/3 or 2/3. The mechanical angular frequency (fm) of the motor (50) corresponds to a rotational frequency of the motor (50).

In the example of Fig. 4, the frequency of the specific frequency component (Cs) is a frequency of "1/3fm", which is obtained by multiplying the mechanical angular frequency (fm) of the motor (50) by "1/3", or a frequency of "2/3fm", which is obtained by multiplying the mechanical angular frequency (fm) of the motor (50) by "2/3". The frequency of the first frequency component (C1) is "1/3fm" or "2/3fm".

As illustrated in Fig. 5, when the signal is an AC signal, the frequency of the first frequency component (C1) is a frequency (first frequency) obtained by subtracting the frequency of the specific frequency component (Cs) from a fundamental frequency (f0) of the signal described above or a frequency (second frequency) obtained by adding the frequency of the specific frequency component (Cs) to the fundamental frequency (f0) of the signal described above.

In the example of Fig. 5, the frequency of the specific frequency component (Cs) is a frequency of "1/3fm", which is obtained by multiplying the mechanical angular frequency (fm) of the motor (50) by "1/3". The first frequency is "f0 - 1/3fm", and the second frequency is "f0 + 1/3fm". The frequency of the first frequency component (C1) is "f0 - 1/3fm" or "f0 + 1/3fm".

By setting the first frequency component (C1) as described above, it is possible to estimate whether the state of the motor (50) is a specific state (an example of an abnormal state) in which variations in the amplitude of the specific frequency component (Cs) less than 1 time the mechanical angular frequency (fm) of the motor (50) occur in the torque of the motor (50). In other words, in this example, when the state of the device (70) is the specific state, the first frequency component (C1) is a frequency component whose amplitude varies in accordance with the variations in amplitude that occur in the torque of the motor (50) (the variations in the amplitude of the specific frequency component (Cs)).

The specific state is a state in which a shaft rotationally driven by the motor (50) or a bearing of the shaft is worn. In other words, the specific state is a state in which the wear amount of the shaft or the bearing exceeds an allowable amount.

If such wear occurs in the shaft or the bearing, the variations in the amplitude of the specific frequency component (Cs) less than 1 time (specifically, 1/3 or 2/3 times) the mechanical angular frequency (fm) of the motor (50) occur in the torque of the motor (50). As a result, the first frequency component (C1) of the signal based on the current or voltage of the motor (50) varies (e.g., varies in amplitude).

(Specific Examples of Estimation Process)

Next, specific examples of the estimation process will be described. Examples of the estimation process include the following four estimation processes (first to fourth estimation processes). Hereinafter, a case where the estimation process is performed based on the amplitude of the first frequency component will be described as an example. In the following description, the "first frequency component" refers to the "amplitude of the first frequency component".

[First Estimation Process]

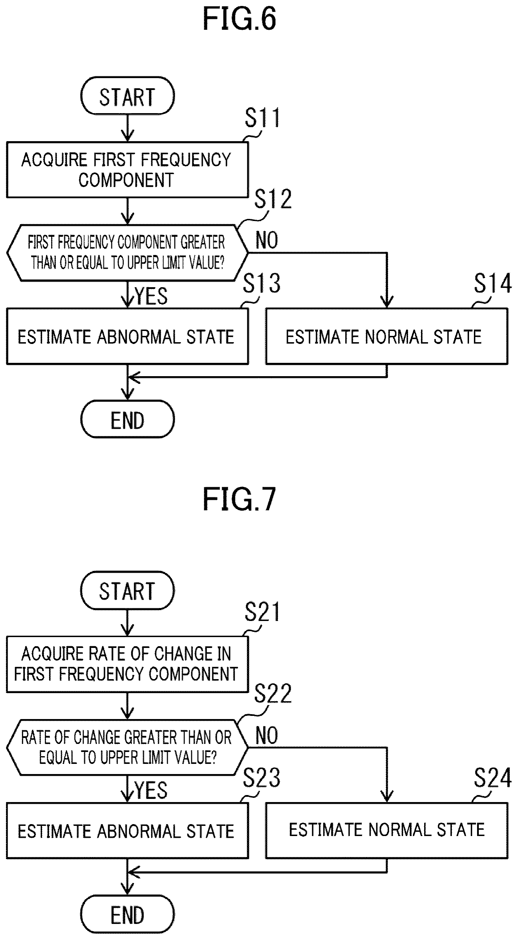

First, the first estimation process will be described with reference to Fig. 6. In the first estimation process, the control unit (31) estimates whether the state of the device (70) is the abnormal state, based on the first frequency component (specifically, an amplitude value of the first frequency component). Specifically, the control unit (31) performs the following process (step (S11) to step (S13)) for each predetermined detection cycle.

<Step (S11)>

The control unit (31) acquires the first frequency component.

<Step (S12)>

Subsequently, the control unit (31) determines whether the first frequency component acquired in step (S11) is greater than or equal to a predetermined upper limit value. The upper limit value is an example of a threshold value used in the estimation process. If the first frequency component is greater than or equal to the upper limit value, the processing of step (S13) is performed. On the other hand, if not, the processing of step (S14) is performed.

<Step (S13)>

If the first frequency component is greater than or equal to the upper limit value in step (S12), the control unit (31) estimates that the state of the device (70) is the abnormal state. Then, the control unit (31) outputs an estimation result indicating that the state of the device (70) is the abnormal state.

<Step (S14)>

On the other hand, if the first frequency component is not greater than or equal to the upper limit value in step (S12), the control unit (31) estimates that the state of the device (70) is a normal state. Then, the control unit (31) outputs an estimation result indicating that the state of the device (70) is the normal state.

[Second Estimation Process]

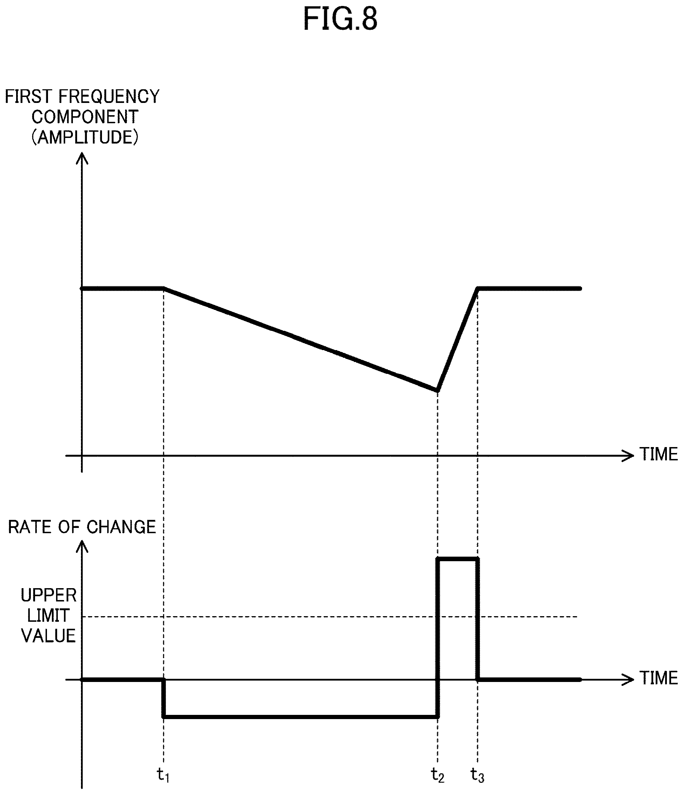

The second estimation process will be described with reference to Figs. 7 and 8. In the second estimation process, the control unit (31) estimates whether the state of the device (70) is the abnormal state, based on a rate of change in the first frequency component. Specifically, the control unit (31) repeatedly performs the following process (step (S21) to step (S23)) for each predetermined detection cycle.

<Step (S21)>

The control unit (31) acquires a rate of change in the first frequency component. For example, the control unit (31) derives the rate of change in the first frequency component by differentiating the first frequency component with respect to time. In an example of Fig. 8, the rate of change in the first frequency component changes at each of times (t1, t2, and t3).

<Step (S22)>

The control unit (31) determines whether the rate of change in the first frequency component acquired in step (S21) is greater than or equal to a predetermined upper limit value. The upper limit value is an example of a threshold value used in the estimation process. If the rate of change in the first frequency component is greater than or equal to the upper limit value, the processing of step (S23) is performed. On the other hand, if not, the processing of step (S24) is performed. In the example of Fig. 8, the rate of change in the first frequency component is greater than or equal to the upper limit value at the time (t2).

<Step (S23)>

If the rate of change in the first frequency component is greater than or equal to the upper limit value in step (S22), the control unit (31) estimates that the state of the device (70) is the abnormal state. Then, the control unit (31) outputs an estimation result indicating that the state of the device (70) is the abnormal state.

<Step (S24)>

On the other hand, if the rate of change in the first frequency component is not greater than or equal to the upper limit value in step (S22), the control unit (31) estimates that the state of the device (70) is the normal state. Then, the control unit (31) outputs an estimation result indicating that the state of the device (70) is the normal state.

[Third Estimation Process]

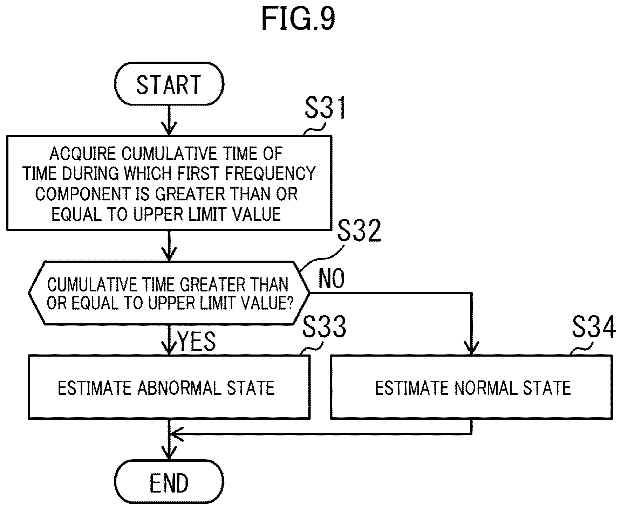

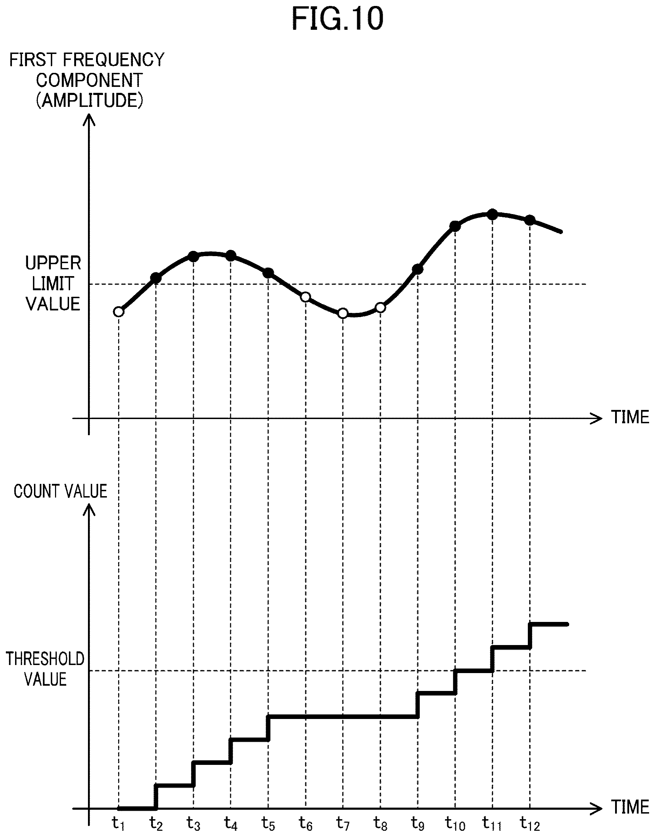

The third estimation process will be described with reference to Figs. 9 and 10. In the third estimation process, the control unit (31) estimates whether the state of the device (70) is the abnormal state, based on a cumulative time obtained by summing the time during which the first frequency component is greater than or equal to an upper limit value. Specifically, the control unit (31) repeatedly performs the following process (step (S31) to step (S33)) for each predetermined detection cycle.

<Step (S31)>

The control unit (31) acquires a cumulative value (cumulative time) of the time during which the first frequency component is greater than or equal to an upper limit value. The upper limit value is an example of a threshold value used in the estimation process.
For example, the control unit (31) acquires a first frequency component that is a representative value in the detection cycle, and determines whether the first frequency component is greater than or equal to the upper limit value. Then, the control unit (31) increments the count value when the first frequency component is greater than or equal to the upper limit value, and does not increment the count value when the first frequency component is not greater than or equal to the upper limit value. The count value corresponds to the cumulative value (cumulative time) of the time during which the first frequency component is greater than or equal to the upper limit value. For example, a value obtained by multiplying the count value by the time corresponding to the detection cycle is the cumulative time.
In an example of Fig. 10, the third estimation process is performed for each of times (t1 to t12), and the count value is incremented at the times (t2 to t5 and t9 to t12) among the times (t1 to t12).

<Step (S32)>

Subsequently, the control unit (31) determines whether the cumulative time (the count value in this example) acquired in step (S31) exceeds a predetermined threshold value. The threshold value is an example of a threshold value used in the estimation process. If the cumulative time exceeds the threshold value, the processing of step (S33) is performed. On the other hand, if not, the processing of step (S34) is performed. In the example of Fig. 10, the control unit (31) determines that the count value exceeds the threshold value at the time (t11).

<Step (S33)>

If the cumulative time exceeds the threshold value in step (S32), the control unit (31) estimates that the state of the device (70) is the abnormal state. Then, the control unit (31) outputs an estimation result indicating that the state of the device (70) is the abnormal state.

<Step (S34)>

On the other hand, if the cumulative time does not exceed the threshold value in step (S32), the control unit (31) estimates that the state of the device (70) is the normal state. Then, the control unit (31) outputs an estimation result indicating that the state of the device (70) is the normal state.

[Fourth Estimation Process]

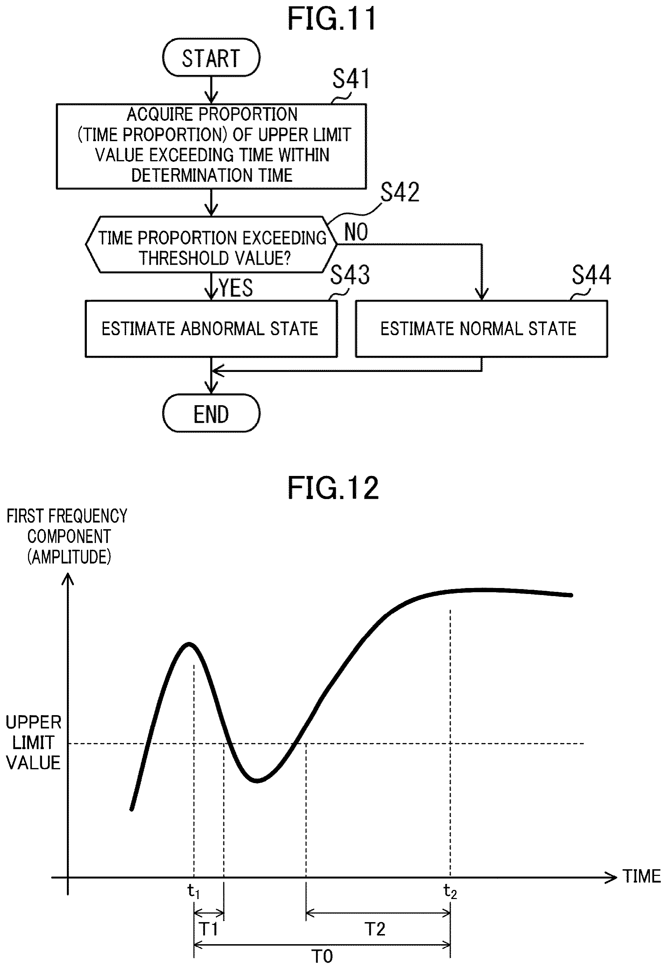

The fourth estimation process will be described with reference to Figs. 11 and 12. In the fourth estimation process, the control unit (31) estimates whether the state of the device (70) is the abnormal state, based on the proportion (time proportion) of the time during which the first frequency component is greater than or equal to a predetermined upper limit value within a predetermined determination time. Specifically, the control unit (31) repeatedly performs the following process (step (S41) to step (S43)) for each predetermined detection cycle.

<Step (S41)>

The control unit (31) acquires the proportion (time proportion) of the time during which the first frequency component is greater than or equal to an upper limit value within a determination time. The upper limit value is an example of a threshold value used in the estimation process.

For example, the control unit (31) stores the first frequency component within a determination period (at least a period corresponding to the determination time) ending at the current time. Then, based on the stored first frequency component, the control unit (31) derives a time (upper limit value exceeding time) during which the first frequency component is greater than or equal to the upper limit value within the determination period ending at the current time and having a duration corresponding to the determination time, and divides the upper limit value exceeding time by the determination time to derive the time proportion. In an example of Fig. 12, a time (t2) is the current time, a period from a time (t1) to the time (t2) is the determination period, a time (T1) and a time (T2) are the upper limit value exceeding times, and a value obtained by dividing the sum of the time (T1) and the time (T2) by a determination time (T0) is the time proportion.

<Step (S42)>

Subsequently, the control unit (31) determines whether the time proportion (the proportion of the time during which the first frequency component is greater than or equal to the upper limit value within the determination time) acquired in step (S41) exceeds a predetermined threshold value. The threshold value is an example of a threshold value used in the estimation process. If the time proportion exceeds the threshold value, the processing of step (S43) is performed. On the other hand, if not, the processing of step (S44) is performed.

<Step (S43)>

If the time proportion exceeds the threshold value in step (S42), the control unit (31) estimates that the state of the device (70) is the abnormal state. Then, the control unit (31) outputs an estimation result indicating that the state of the device (70) is the abnormal state.

<Step (S44)>

On the other hand, if the time proportion does not exceed the threshold value in step (S42), the control unit (31) estimates that the state of the device (70) is the normal state. Then, the control unit (31) outputs an estimation result indicating that the state of the device (70) is the normal state.

In the above description of the estimation process, a case where the first frequency component is compared with the upper limit value has been described as an example, but is not intended to be limiting. For example, the first frequency component may be compared with a predetermined lower limit value. That is, in the above description, "greater than or equal to the upper limit value" may be interpreted as "less than or equal to the lower limit value". Alternatively, the first frequency component may be compared with a predetermined allowable range. That is, in the above description, "greater than or equal to the upper limit value" may be interpreted as "out of the allowable range".

(Specific Examples of Process for Restricting Estimation Process)

Next, specific examples of the "process for restricting the estimation process" performed in the restriction process will be described. Examples of the process for restricting the estimation process include the following five processes (first to fifth processes).

[First Process]

First, the first process will be described. In the first process, the control unit (31) stops the estimation process and outputs a predetermined estimation result. Thus, the estimation process is directly restricted so that a predetermined estimation result is output.

[Second Process]

Next, the second process will be described. In the second process, while continuing the estimation process, the control unit (31) corrects the estimation result obtained by the estimation process to a "predetermined estimation result". Thus, the estimation process is directly restricted so that a predetermined estimation result is output.

[Third Process]

Next, the third process will be described. In the third process, the control unit (31) stops the calculation process, and sets the feature quantity used in the estimation process to a "predetermined feature quantity" so that a predetermined estimation result is obtained in the estimation process. Thus, the estimation process is indirectly restricted so that a predetermined estimation result is output.

[Fourth Process]

Next, the fourth process will be described. In the fourth process, while continuing the calculation process, the control unit (31) corrects the feature quantity calculated by the calculation process to a "predetermined feature quantity" so that a predetermined estimation result is obtained in the estimation process. Thus, the estimation process is indirectly restricted so that a predetermined estimation result is output.

[Fifth Process]

Next, the fifth process will be described. In the fifth process, the control unit (31) corrects the threshold value used in the estimation process to a "predetermined threshold value" so that a predetermined estimation result is obtained in the estimation process. Thus, the estimation process is directly restricted so that a predetermined estimation result is output.

(Specific Examples of Standby Release Condition)

Next, specific examples of the standby release condition will be described. Examples of the standby release condition include the following three standby release conditions (first to third standby release conditions).

[First Standby Release Condition]

First, the first standby release condition will be described. The first standby release condition is a condition that a predetermined time elapses from a time point at which the restriction release condition is satisfied. When the restriction release condition is satisfied, the control unit (31) releases the restriction of the estimation process after a predetermined time elapses. Specifically, when the restriction release condition is satisfied, the control unit (31) starts to measure an elapsed time. When the elapsed time reaches the predetermined time, the control unit (31) releases the restriction of the estimation process. The predetermined time is set to, for example, a time longer than the time required for the feature quantity to change from the unsteady state to the steady state. Alternatively, the predetermined time may be set to a time longer than a time corresponding to a predetermined period. The predetermined period is the "predetermined period" of the "physical quantity obtained from the device (70) within the predetermined period".

[Second Standby Release Condition]

Next, the second standby release condition will be described. The second standby release condition is a condition that the number of consecutive times the restriction release condition is satisfied reaches a predetermined number of times. The control unit (31) repeatedly determines whether the restriction release condition is satisfied. When the restriction release condition is satisfied, the control unit (31) releases the restriction of the estimation process after the number of consecutive times the restriction release condition is satisfied reaches a predetermined number of times. Specifically, when the restriction release condition is satisfied, the control unit (31) starts to count the number of consecutive times the restriction release condition is satisfied. When the number of consecutive times the restriction release condition is satisfied reaches a predetermined number of times, the control unit (31) releases the restriction of the estimation process. The predetermined number of times is set to, for example, a number of times greater than the number of consecutive times the restriction release condition is satisfied measured until the feature quantity changes from the unsteady state to the steady state.

[Third Standby Release Condition]

Next, the third standby release condition will be described. The third standby release condition is a condition that the feature quantity calculated by the calculation process is brought into a steady state. The control unit (31) monitors the feature quantity calculated by the calculation process, and, when a restriction release condition is satisfied, releases the restriction of the estimation process after the feature quantity calculated by the calculation process is brought into the steady state. Specifically, when the restriction release condition is satisfied, the control unit (31) determines whether the feature quantity calculated by the calculation process is in the steady state. When the control unit (31) determines that the feature quantity calculated by the calculation process is in the steady state, the control unit (31) releases the restriction of the estimation process.

The steady state of the feature quantity is, for example, a state in which the ratio of the current value to the previous value of the moving average of the feature quantity within a predetermined time is within a predetermined range. For example, the moving average within the predetermined time is the moving average for a period of one second, the previous value is the moving average acquired one second before (immediately before) the current value, and the predetermined range is 99 to 101%. The unsteady state of the feature quantity is a state in which the ratio of the current value to the previous value of the moving average of the feature quantity within the predetermined time is out of the predetermined range.

(Embodiment 2)

A drive system (10) according to Embodiment 2 is different from the drive system (10) according to Embodiment 1 in the estimation restriction condition and the restriction release condition. Other configurations and processes of the drive system (10) according to Embodiment 2 are similar to the configurations and processes of the drive system (10) according to Embodiment 1.

An estimation restriction condition according to Embodiment 2 is a condition that a control mode of the motor (50) changes. A restriction release condition according to Embodiment 2 is a condition that the control mode of the motor (50) changes after the estimation restriction condition is satisfied. In a restriction process according to Embodiment 2, when the control mode of the motor (50) changes, the control unit (31) restricts the estimation process so that a predetermined estimation result is output, and then when the control mode of the motor (50) changes, the control unit (31) releases the restriction of the estimation process after a predetermined standby release condition is satisfied.

For example, the estimation restriction condition according to Embodiment 2 is a condition that the control mode of the motor (50) changes from a "predetermined control mode" to a "control mode other than the predetermined control mode", and the restriction release condition according to Embodiment 2 is a condition that the control mode of the motor (50) changes from a "control mode other than the predetermined control mode" to the "predetermined control mode". Alternatively, the estimation restriction condition according to Embodiment 2 is a condition that the control mode of the motor (50) changes from a "control mode other than the predetermined control mode" to the "predetermined control mode", and the restriction release condition according to Embodiment 2 is a condition that the control mode of the motor (50) changes from the "predetermined control mode" to a "control mode other than the predetermined control mode".

The control mode of the motor (50) may be managed by the control unit (31). For example, the control unit (31) stores mode information indicating the current control mode of the motor (50) in a storage unit (not illustrated), and updates the mode information stored in the storage unit when the control mode of the motor (50) changes.

Examples of the control mode include flux weakening control, speed droop control, startup control, beat suppression control, torque control, resonance suppression control, slot ripple suppression control, modulation method switching control, and rectangular-wave drive control. The speed droop control is a control mode for restricting the magnitude of the current vector amplitude by speed droop. The startup control is a control mode performed at the time of startup of the motor (50). The beat suppression control is a control mode for suppressing the beat caused by the power source frequency and the rotational frequency. The torque control is a control mode for varying the output torque of the motor (50) in accordance with the variation in load torque to suppress the vibration of the compressor. The resonance suppression control is a control mode for suppressing the resonance caused by a reactor and the capacitor. The slot ripple suppression control is a control mode for suppressing electric power pulsation caused by slot ripple. The modulation method switching control is a control mode for switching the modulation method. The modulation method switching control is disclosed in Japanese Patent No. 6103031 and so on.

For example, the estimation restriction condition according to Embodiment 2 is a condition that the control mode changes from a "control mode other than the flux weakening control among the control modes described above" to the "flux weakening control". The restriction release condition according to Embodiment 2 is a condition that the control mode changes from the "flux weakening control" to a "control mode other than the flux weakening control among the control modes described above".

[Effects of Embodiment 2]

In Embodiment 2, effects similar to those of Embodiment 1 can be obtained.

In Embodiment 2, the estimation restriction condition is a condition that the control mode of the motor (50) changes. The restriction release condition is a condition that the control mode of the motor (50) changes after the estimation restriction condition is satisfied.

In Embodiment 2, the change in the control mode of the motor (50) correlates with an unintended variation that occurs in the feature quantity calculated from the physical quantity obtained from the device (70) within the predetermined period. For example, when the control mode of the motor (50) does not change, an unintended variation tends to be unlikely to occur in the feature quantity, and when the control mode of the motor (50) changes, an unintended variation tends to be likely to occur in the feature quantity in the immediately subsequent period. By monitoring the change in the control mode of the motor (50), it is possible to check whether an unintended variation is occurring in the feature quantity. Thus, by restricting the estimation process and releasing the restriction of the estimation process based on the change in the control mode of the motor (50), it is possible to appropriately restrict the estimation process and release the restriction of the estimation process.

(Modification of Embodiment 2)

When the estimation restriction condition according to Embodiment 2 is a condition that "the control mode of the motor (50) changes", the estimation restriction condition according to Embodiment 2 may be a condition that "the estimation process is restricted in accordance with a change in the control mode of the motor (50)". In this case, in the restriction process, when the control mode of the motor (50) changes, the control unit (31) restricts the estimation process so that a predetermined estimation result is output, and then releases the restriction of the estimation process after the predetermined standby release condition is satisfied.

In summary, the estimation restriction condition according to Embodiment 2 may be a first condition that "the control mode of the motor (50) changes after the estimation process is restricted", or a second condition that "when the estimation restriction condition is a condition that the control mode of the motor (50) changes, the estimation process is restricted in accordance with a change in the control mode of the motor (50)".

(Embodiment 3)

A drive system (10) according to Embodiment 3 is different from the drive system (10) according to Embodiment 1 in the estimation restriction condition and the restriction release condition. Other configurations and processes of the drive system (10) according to Embodiment 3 are similar to the configurations and processes of the drive system (10) according to Embodiment 1.

An estimation restriction condition according to Embodiment 3 is a condition that an "integer multiple of the frequency of the voltage of the power source (60)" is in the vicinity of an "integer multiple or M/N multiple of the rotational frequency of the motor (50)". M and N are integers. For example, M/N is 1/3 or 2/3. A restriction release condition according to Embodiment 3 is a condition that an "integer multiple of the frequency of the voltage of the power source (60)" is outside the vicinity of an "integer multiple or M/N multiple of the rotational frequency of the motor (50)". In a restriction process according to Embodiment 3, when an integer multiple of the frequency of the voltage of the power source (60) is in the vicinity of an integer multiple or M/N multiple of the rotational frequency of the motor (50), the control unit (31) restricts the estimation process so that a predetermined estimation result is output, and when an integer multiple of the frequency of the voltage of the power source (60) is outside the vicinity of an integer multiple or M/N multiple of the rotational frequency of the motor (50), the control unit (31) releases the restriction of the estimation process after a predetermined standby release condition is satisfied.

The voltage of the power source (60) may be detected by, for example, a power source voltage detection unit (not illustrated) provided in the drive system (10). The voltage of the power source (60) detected by the power source voltage detection unit is transmitted to the control unit (31). The control unit (31) may monitor the voltage of the power source (60) to derive the frequency of the voltage of the power source (60).

The rotational frequency of the motor (50) may be derived by, for example, the electrical angular frequency detection unit (42), based on the electrical angular frequency ($\omega$) of the motor (50). The rotational frequency of the motor (50) may be derived by the control unit (31). Alternatively, the rotational frequency of the motor (50) may be detected by a rotational frequency detection unit (not illustrated) provided in the drive system (10). The rotational frequency of the motor (50) detected by the rotational frequency detection unit is transmitted to the control unit (31).

The state in which an "integer multiple of the frequency of the voltage of the power source (60) is in the vicinity of an integer multiple or M/N multiple of the rotational frequency of the motor (50)" is, for example, a state in which the difference between the integer multiple of the frequency of the voltage of the power source (60) and the integer multiple or M/N multiple of the rotational frequency of the motor (50) is within 1 Hz. The state in which an "integer multiple of the frequency of the voltage of the power source (60) is outside the vicinity of an integer multiple or M/N multiple of the rotational frequency of the motor (50)" is a state in which the difference between the integer multiple of the frequency of the voltage of the power source (60) and the integer multiple or M/N multiple of the rotational frequency of the motor (50) is greater than 1 Hz.

[Effects of Embodiment 3]

In Embodiment 3, effects similar to those of Embodiment 1 can be obtained.

In Embodiment 3, the estimation restriction condition is a condition that an integer multiple of the frequency of the voltage of the power source (60) is in the vicinity of an integer multiple or M/N multiple of the rotational frequency of the motor (50). The restriction release condition is a condition that an integer multiple of the frequency of the voltage of the power source (60) is outside the vicinity of an integer multiple or M/N multiple of the rotational frequency of the motor (50).

In Embodiment 3, the relationship between an integer multiple of the frequency of the voltage of the power source (60) and an integer multiple or M/N multiple of the rotational frequency of the motor (50) correlates with an unintended variation that occurs in the feature quantity calculated from the physical quantity obtained from the device (70) within the predetermined period. For example, when an integer multiple of the frequency of the voltage of the power source (60) is outside the vicinity of an integer multiple or M/N multiple of the rotational frequency of the motor (50), an unintended variation tends to be unlikely to occur in the feature quantity, and when an integer multiple of the frequency of the voltage of the power source (60) is in the vicinity of an integer multiple or M/N multiple of the rotational frequency of the motor (50), an unintended variation tends to be likely to occur in the feature quantity. By monitoring the relationship between an integer multiple of the frequency of the voltage of the power source (60) and an integer multiple or M/N multiple of the rotational frequency of the motor (50), it is possible to check whether an unintended variation is occurring in the feature quantity. Thus, by restricting the estimation process and releasing the restriction of the estimation process based on the relationship between an integer multiple of the frequency of the voltage of the power source (60) and an integer multiple or M/N multiple of the rotational frequency of the motor (50), it is possible to appropriately restrict the estimation process and release the restriction of the estimation process.

(Embodiment 4)

A drive system (10) according to Embodiment 4 is different from the drive system (10) according to Embodiment 1 in the estimation restriction condition and the restriction release condition. Other configurations and processes of the drive system (10) according to Embodiment 4 are similar to the configurations and processes of the drive system (10) according to Embodiment 1.

An estimation restriction condition according to Embodiment 4 is a condition that the voltage of the DC unit (22) changes from a steady state to an unsteady state. A restriction release condition according to Embodiment 4 is a condition that the voltage of the DC unit (22) changes from the unsteady state to the steady state. In a restriction process according to Embodiment 4, when the voltage of the DC unit (22) changes from the steady state to the unsteady state, the control unit (31) restricts the estimation process so that a predetermined estimation result is output, and when the voltage of the DC unit (22) changes from the unsteady state to the steady state, the control unit (31) releases the restriction of the estimation process after a predetermined standby release condition is satisfied.

The voltage of the DC unit (22) may be detected by, for example, a DC voltage detection unit (not illustrated) provided in the drive system (10). The voltage of the DC unit (22) detected by the DC voltage detection unit is transmitted to the control unit (31).

The steady state of the voltage of the DC unit (22) is, for example, a state in which an instantaneous value of an AC component extracted from an instantaneous waveform of the voltage of the DC unit (22) is less than or equal to a threshold value. The threshold value is set to, for example, a value obtained by multiplying the average value of AC components extracted from the instantaneous waveform of the voltage of the DC unit (22) by a predetermined coefficient. The unsteady state of the voltage of the DC unit (22) is a state in which an instantaneous value of an AC component extracted from the instantaneous waveform of the voltage of the DC unit (22) is greater than the threshold value.

[Effects of Embodiment 4]

In Embodiment 4, effects similar to those of Embodiment 1 can be obtained.

In Embodiment 4, the estimation restriction condition is a condition that the voltage of the DC unit (22) changes from the steady state to the unsteady state. The restriction release condition is a condition that the voltage of the DC unit (22) changes from the unsteady state to the steady state.

In Embodiment 4, the state of the voltage of the DC unit (22) correlates with an unintended variation that occurs in the feature quantity calculated from the physical quantity obtained from the device (70) within the predetermined period. For example, when the voltage of the DC unit (22) is in the steady state, an unintended variation tends to be unlikely to occur in the feature quantity, and when the voltage of the DC unit (22) is in the unsteady state, an unintended variation tends to be likely to occur in the feature quantity. By monitoring the state of the voltage of the DC unit (22), it is possible to check whether an unintended variation is occurring in the feature quantity. Thus, by restricting the estimation process and releasing the restriction of the estimation process based on the change in the state of the voltage of the DC unit (22), it is possible to appropriately restrict the estimation process and release the restriction of the estimation process.

(Embodiment 5)

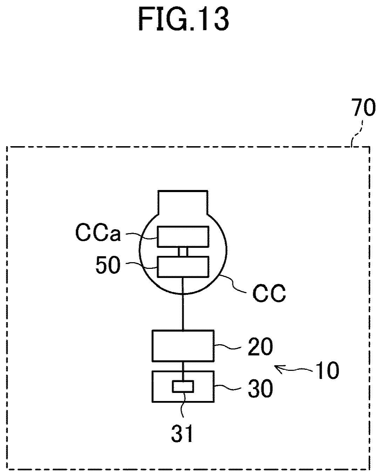

Fig. 13 illustrates a configuration of a drive system (10) according to Embodiment 5. The drive system (10) according to Embodiment 5 is mounted in a device (70) in which a compressor (CC) including a motor (50) is mounted. The drive system (10) according to Embodiment 5 is different from the drive system (10) according to Embodiment 1 in the estimation restriction condition and the restriction release condition. Other configurations and processes of the drive system (10) according to Embodiment 5 are similar to the configurations and processes of the drive system (10) according to Embodiment 1.

In the drive system (10) according to Embodiment 5, the control device (30) is an example of a state estimation device that estimates the state of the device (70) in which the compressor (CC) including the motor (50) is mounted.

An estimation restriction condition according to Embodiment 5 is a condition that the pressure of a fluid flowing into the compressor (CC) or the pressure of a fluid flowing out of the compressor (CC) changes from a steady state to an unsteady state. Examples of the fluid flowing into the compressor (CC) include a fluid to be sucked into a suction port of the compressor (CC) and a fluid to be supplied to an injection port of the compressor (CC). Examples of the fluid flowing out of the compressor (CC) include a fluid discharged from a discharge port of the compressor (CC). Hereinafter, the pressure of the fluid flowing into the compressor (CC) is referred to as an "inflow pressure", and the pressure of the fluid flowing out of the compressor (CC) is referred to as an "outflow pressure".

Specifically, the estimation restriction condition according to Embodiment 5 is a condition that one of the inflow pressure and the outflow pressure of the compressor (CC) is to be monitored and that the pressure to be monitored changes from the steady state to the unsteady state. Alternatively, the estimation restriction condition according to Embodiment 5 is a condition that both the inflow pressure and the outflow pressure of the compressor (CC) are to be monitored and that at least one of the inflow pressure and the outflow pressure of the compressor (CC) changes from the steady state to the unsteady state.

A restriction release condition according to Embodiment 5 is a condition that the inflow pressure or the outflow pressure of the compressor (CC) changes from the unsteady state to the steady state. In the restriction release condition according to Embodiment 5, the "pressure to be monitored in the estimation restriction condition" among the inflow pressure and the outflow pressure of the compressor (CC) is to be monitored.

Specifically, the restriction release condition according to Embodiment 5 is a condition that one of the inflow pressure and the outflow pressure of the compressor (CC) is to be monitored and that the pressure to be monitored changes from the unsteady state to the steady state. Alternatively, the restriction release condition according to Embodiment 5 is a condition that both the inflow pressure and the outflow pressure of the compressor (CC) are to be monitored and that both the inflow pressure and the outflow pressure of the compressor (CC) are brought into the unsteady state.

In a restriction process according to Embodiment 5, when the inflow pressure or the outflow pressure of the compressor (CC) changes from the steady state to the unsteady state, the control unit (31) restricts the estimation process so that a predetermined estimation result is output, and when the inflow pressure or the outflow pressure of the compressor (CC) changes from the unsteady state to the steady state, the control unit (31) releases the restriction of the estimation process after a predetermined standby release condition is satisfied.

Specifically, in the restriction process according to Embodiment 5, when one of the inflow pressure and the outflow pressure of the compressor (CC) (the pressure to be monitored) changes from the steady state to the unsteady state, the control unit (31) restricts the estimation process so that a predetermined estimation result is output, and when one of the inflow pressure and the outflow pressure of the compressor (CC) (the pressure to be monitored) changes from the unsteady state to the steady state, the control unit (31) releases the restriction of the estimation process after a predetermined standby release condition is satisfied.

Alternatively, in the restriction process according to Embodiment 5, when at least one of the inflow pressure and the outflow pressure of the compressor (CC) changes from the steady state to the unsteady state, the control unit (31) restricts the estimation process so that a predetermined estimation result is output, and when both the inflow pressure and the outflow pressure of the compressor (CC) are brought into the steady state, the control unit (31) releases the restriction of the estimation process after a predetermined standby release condition is satisfied.

The inflow pressure of the compressor (CC) may be detected by an inflow pressure detection unit (not illustrated) provided in an inflow portion (e.g., the suction port) of the compressor (CC). The inflow pressure of the compressor (CC) detected by the inflow pressure detection unit is transmitted to the control unit (31). Similarly, the outflow pressure of the compressor (CC) may be detected by an outflow pressure detection unit (not illustrated) provided in an outflow portion (e.g., the discharge port) of the compressor (CC). The outflow pressure of the compressor (CC) detected by the outflow pressure detection unit is transmitted to the control unit (31).

The steady state of the inflow pressure of the compressor (CC) is, for example, a state in which the difference between the current value and the previous value of the inflow pressure of the compressor (CC) is within a predetermined difference. For example, the previous value is the inflow pressure of the compressor (CC) acquired one second before the current value, and the predetermined difference is 0.1 MPa. The unsteady state of the inflow pressure of the compressor (CC) is, for example, a state in which the difference between the current value and the previous value of the inflow pressure of the compressor (CC) is greater than the predetermined difference.

Alternatively, the steady state of the inflow pressure of the compressor (CC) may be a state in which the difference between the current value and the previous value of the saturation temperature of the fluid flowing into the compressor (CC) is within a predetermined difference. Hereinafter, the saturation temperature of the fluid flowing into the compressor (CC) is referred to as an "inflow saturation temperature". For example, the previous value is the inflow saturation temperature of the compressor (CC) acquired one second before the current value, and the predetermined difference is 0.1°C. The unsteady state of the inflow pressure of the compressor (CC) may be a state in which the difference between the current value and the previous value of the inflow saturation temperature of the compressor (CC) is greater than the predetermined difference.

Alternatively, the steady state of the inflow pressure of the compressor (CC) may be a state in which the difference between the "moving average of the inflow pressure of the compressor (CC) within a first time" and the "moving average of the inflow pressure of the compressor (CC) within a second time" is within a predetermined difference. The second time is shorter than the first time. For example, the moving average within the first time is the moving average for a period of 3 minutes, the moving average within the second time is the moving average for a period of 10 seconds, and the predetermined difference is 1 MPa. The unsteady state of the inflow pressure of the compressor (CC) may be a state in which the difference between the "moving average of the inflow pressure of the compressor (CC) within the first time" and the "moving average of the inflow pressure of the compressor (CC) within the second time" is greater than the predetermined difference.

The steady state of the outflow pressure of the compressor (CC) is, for example, a state in which the difference between the current value and the previous value of the outflow pressure of the compressor (CC) is within a predetermined difference. For example, the previous value is the outflow pressure of the compressor (CC) acquired one second before the current value, and the predetermined difference is 0.1 MPa. The unsteady state of the outflow pressure of the compressor (CC) is, for example, a state in which the difference between the current value and the previous value of the outflow pressure of the compressor (CC) is greater than the predetermined difference.

Alternatively, the steady state of the outflow pressure of the compressor (CC) may be a state in which the difference between the current value and the previous value of the saturation temperature of the fluid flowing out of the compressor (CC) is within a predetermined difference. Hereinafter, the saturation temperature of the fluid flowing out of the compressor (CC) is referred to as an "outflow saturation temperature". For example, the previous value is the outflow saturation temperature of the compressor (CC) acquired one second before the current value, and the predetermined difference is 0.1°C. The unsteady state of the outflow pressure of the compressor (CC) may be a state in which the difference between the current value and the previous value of the outflow saturation temperature of the compressor (CC) is greater than the predetermined difference.

Alternatively, the steady state of the outflow pressure of the compressor (CC) may be a state in which the difference between the "moving average of the outflow pressure of the compressor (CC) within a first time" and the "moving average of the outflow pressure of the compressor (CC) within a second time" is within a predetermined difference. The second time is shorter than the first time. For example, the moving average within the first time is the moving average for a period of 3 minutes, the moving average within the second time is the moving average for a period of 10 seconds, and the predetermined difference is 1 MPa. The unsteady state of the outflow pressure of the compressor (CC) may be a state in which the difference between the "moving average of the outflow pressure of the compressor (CC) within the first time" and the "moving average of the outflow pressure of the compressor (CC) within the second time" is greater than the predetermined difference.

[Effects of Embodiment 5]

In Embodiment 5, effects similar to those of Embodiment 1 can be obtained.

In Embodiment 5, the estimation restriction condition is a condition that the inflow pressure or the outflow pressure of the compressor (CC) changes from the steady state to the unsteady state. The restriction release condition is a condition that the inflow pressure or the outflow pressure of the compressor (CC) changes from the unsteady state to the steady state.

In Embodiment 5, the state of the inflow pressure or the outflow pressure of the compressor (CC) correlates with an unintended variation that occurs in the feature quantity calculated from the physical quantity obtained from the device (70) within the predetermined period. For example, when the inflow pressure and the outflow pressure of the compressor (CC) are in the steady state, an unintended variation tends to be unlikely to occur in the feature quantity, and when the inflow pressure or the outflow pressure of the compressor (CC) is in the unsteady state, an unintended variation tends to be likely to occur in the feature quantity. By monitoring the state of the inflow pressure or the outflow pressure of the compressor (CC), it is possible to check whether an unintended variation is occurring in the feature quantity. Thus, by restricting the estimation process and releasing the restriction of the estimation process based on the change in the state of the inflow pressure or the outflow pressure of the compressor (CC), it is possible to appropriately restrict the estimation process and release the restriction of the estimation process.

(Modification of Embodiment 5)

In Embodiment 5, the control unit (31) may determine the change in the inflow pressure or the outflow pressure of the compressor (CC) from the unsteady state to the steady state, based on the effective value or the current vector amplitude of the current flowing through the motor (50). Hereinafter, the current flowing through the motor (50) is referred to as a "motor current".

The control unit (31) may determine that the inflow pressure (or the outflow pressure) of the compressor (CC) has changed from the unsteady state to the steady state, for example, when a state in which the "ratio of the current value to the previous value of the moving average of the effective value (or the current vector amplitude) of the motor current within a predetermined time is out of a predetermined range" is changed to a state in which the "ratio of the current value to the previous value of the moving average of the effective value (or the current vector amplitude) of the motor current within the predetermined time is within the predetermined range". For example, the moving average within the predetermined time is the moving average for a period of one second, the previous value is the moving average acquired one second before (immediately before) the current value, and the predetermined range is 99 to 101%.

(Embodiment 6)

A drive system (10) according to Embodiment 6 is mounted in a device (70) in which a compressor (CC) including a motor (50) is mounted, like the drive system (10) according to Embodiment 5 illustrated in Fig. 13. The drive system (10) according to Embodiment 6 is different from the drive system (10) according to Embodiment 1 in the estimation restriction condition and the restriction release condition. Other configurations and processes of the drive system (10) according to Embodiment 6 are similar to the configurations and processes of the drive system (10) according to Embodiment 1.

In the drive system (10) according to Embodiment 6, the control device (30) is an example of a state estimation device that estimates the state of the device (70) in which the compressor (CC) including the motor (50) is mounted.

An estimation restriction condition according to Embodiment 6 is a condition that the temperature of a fluid flowing into the compressor (CC) or the temperature of a fluid flowing out of the compressor (CC) changes from a steady state to an unsteady state. Hereinafter, the temperature of the fluid flowing into the compressor (CC) is referred to as an "inflow temperature", and the temperature of the fluid flowing out of the compressor (CC) is referred to as an "outflow temperature".

Specifically, the estimation restriction condition according to Embodiment 6 is a condition that one of the inflow temperature and the outflow temperature of the compressor (CC) is to be monitored and that the temperature to be monitored changes from the steady state to the unsteady state. Alternatively, the estimation restriction condition according to Embodiment 6 is a condition that both the inflow temperature and the outflow temperature of the compressor (CC) are to be monitored and that at least one of the inflow temperature and the outflow temperature of the compressor (CC) changes from the steady state to the unsteady state.

A restriction release condition according to Embodiment 6 is a condition that the inflow temperature or the outflow temperature of the compressor (CC) changes from the unsteady state to the steady state. In the restriction release condition according to Embodiment 6, the "temperature to be monitored in the estimation restriction condition" among the inflow temperature and the outflow temperature of the compressor (CC) is to be monitored.

Specifically, the restriction release condition according to Embodiment 6 is a condition that one of the inflow temperature and the outflow temperature of the compressor (CC) is to be monitored and that the temperature to be monitored changes from the unsteady state to the steady state. Alternatively, the restriction release condition according to Embodiment 6 is a condition that both the inflow temperature and the outflow temperature of the compressor (CC) are to be monitored and that both the inflow temperature and the outflow temperature of the compressor (CC) are brought into the unsteady state.

In a restriction process according to Embodiment 6, when the inflow temperature or the outflow temperature of the compressor (CC) changes from the steady state to the unsteady state, the control unit (31) restricts the estimation process so that a predetermined estimation result is output, and when the inflow temperature or the outflow temperature of the compressor (CC) changes from the unsteady state to the steady state, the control unit (31) releases the restriction of the estimation process after a predetermined standby release condition is satisfied.

Specifically, in the restriction process according to Embodiment 6, when one of the inflow temperature and the outflow temperature of the compressor (CC) (the temperature to be monitored) changes from the steady state to the unsteady state, the control unit (31) restricts the estimation process so that a predetermined estimation result is output, and when one of the inflow temperature and the outflow temperature of the compressor (CC) (the temperature to be monitored) changes from the unsteady state to the steady state, the control unit (31) releases the restriction of the estimation process after a predetermined standby release condition is satisfied.

Alternatively, in the restriction process according to Embodiment 6, when at least one of the inflow temperature and the outflow temperature of the compressor (CC) changes from the steady state to the unsteady state, the control unit (31) restricts the estimation process so that a predetermined estimation result is output, and when both the inflow temperature and the outflow temperature of the compressor (CC) are brought into the steady state, the control unit (31) releases the restriction of the estimation process after a predetermined standby release condition is satisfied.

The inflow temperature of the compressor (CC) may be detected by an inflow temperature detection unit (not illustrated) provided in the inflow portion (e.g., the suction port) of the compressor (CC). The inflow temperature of the compressor (CC) detected by the inflow temperature detection unit is transmitted to the control unit (31). Similarly, the outflow temperature of the compressor (CC) may be detected by an outflow temperature detection unit (not illustrated) provided in the outflow portion (e.g., the discharge port) of the compressor (CC). The outflow temperature of the compressor (CC) detected by the outflow temperature detection unit is transmitted to the control unit (31).

The steady state of the inflow temperature of the compressor (CC) is, for example, a state in which the difference between the current value and the previous value of the inflow temperature of the compressor (CC) is within a predetermined difference. For example, the previous value is the inflow temperature of the compressor (CC) acquired one second before the current value, and the predetermined difference is 0.1°C. The unsteady state of the inflow temperature of the compressor (CC) is, for example, a state in which the difference between the current value and the previous value of the inflow temperature of the compressor (CC) is greater than the predetermined difference.

Alternatively, the steady state of the inflow temperature of the compressor (CC) may be a state in which the difference between the "moving average of the inflow temperature of the compressor (CC) within a first time" and the "moving average of the inflow temperature of the compressor (CC) within a second time" is within a predetermined difference. The second time is shorter than the first time. For example, the moving average within the first time is the moving average for a period of 3 minutes, the moving average within the second time is the moving average for a period of 10 seconds, and the predetermined difference is 1°C. The unsteady state of the inflow temperature of the compressor (CC) may be a state in which the difference between the "moving average of the inflow temperature of the compressor (CC) within the first time" and the "moving average of the inflow temperature of the compressor (CC) within the second time" is greater than the predetermined difference.

The steady state of the outflow temperature of the compressor (CC) is, for example, a state in which the difference between the current value and the previous value of the outflow temperature of the compressor (CC) is within a predetermined difference. For example, the previous value is the outflow temperature of the compressor (CC) acquired one second before the current value, and the predetermined difference is 0.1°C. The unsteady state of the outflow temperature of the compressor (CC) is, for example, a state in which the difference between the current value and the previous value of the outflow temperature of the compressor (CC) is greater than the predetermined difference.

Alternatively, the steady state of the outflow temperature of the compressor (CC) may be a state in which the difference between the "moving average of the outflow temperature of the compressor (CC) within a first time" and the "moving average of the outflow temperature of the compressor (CC) within a second time" is within a predetermined difference. The second time is shorter than the first time. For example, the moving average within the first time is the moving average for a period of 3 minutes, the moving average within the second time is the moving average for a period of 10 seconds, and the predetermined difference is 1°C. The unsteady state of the outflow temperature of the compressor (CC) may be a state in which the difference between the "moving average of the outflow temperature of the compressor (CC) within the first time" and the "moving average of the outflow temperature of the compressor (CC) within the second time" is greater than the predetermined difference.

[Effects of Embodiment 6]

In Embodiment 6, effects similar to those of Embodiment 1 can be obtained.

In Embodiment 6, the estimation restriction condition is a condition that the inflow temperature or the outflow temperature of the compressor (CC) changes from the steady state to the unsteady state. The restriction release condition is a condition that the inflow temperature or the outflow temperature of the compressor (CC) changes from the unsteady state to the steady state.

In Embodiment 6, the state of the inflow temperature or the outflow temperature of the compressor (CC) correlates with an unintended variation that occurs in the feature quantity calculated from the physical quantity obtained from the device (70) within the predetermined period. For example, when the inflow temperature and the outflow temperature of the compressor (CC) are in the steady state, an unintended variation tends to be unlikely to occur in the feature quantity, and when the inflow temperature or the outflow temperature of the compressor (CC) is in the unsteady state, an unintended variation tends to be likely to occur in the feature quantity. By monitoring the state of the inflow temperature or the outflow temperature of the compressor (CC), it is possible to check whether an unintended variation is occurring in the feature quantity. Thus, by restricting the estimation process and releasing the restriction of the estimation process based on the change in the state of the inflow temperature or the outflow temperature of the compressor (CC), it is possible to appropriately restrict the estimation process and release the restriction of the estimation process.

(Embodiment 7)

A drive system (10) according to Embodiment 7 is mounted in a device (70) in which a compressor (CC) including a motor (50) is mounted, like the drive system (10) according to Embodiment 5 illustrated in Fig. 13. The drive system (10) according to Embodiment 7 is different from the drive system (10) according to Embodiment 1 in the estimation restriction condition and the restriction release condition. Other configurations and processes of the drive system (10) according to Embodiment 7 are similar to the configurations and processes of the drive system (10) according to Embodiment 1.

In the drive system (10) according to Embodiment 7, the control device (30) is an example of a state estimation device that estimates the state of the device (70) in which the compressor (CC) including the motor (50) is mounted.

[Estimation Restriction Condition]

An estimation restriction condition according to Embodiment 7 includes at least two of first to sixth restriction conditions. In Embodiment 7, when at least one of the restriction conditions included in the estimation restriction condition is satisfied, the estimation restriction condition is satisfied. In this example, the estimation restriction condition includes all of the first to sixth restriction conditions.

The first restriction condition is a condition that the number of rotations of the motor (50) changes from a steady state to an unsteady state.

The second restriction condition is a condition that the pressure of a fluid flowing into the compressor (CC) or the pressure of a fluid flowing out of the compressor (CC) changes from a steady state to an unsteady state.

The third restriction condition is a condition that the temperature of a fluid flowing into the compressor (CC) or the temperature of a fluid flowing out of the compressor (CC) changes from a steady state to an unsteady state.

The fourth restriction condition is a condition that the control mode of the motor (50) changes. For example, the fourth restriction condition is a condition that the control mode of the motor (50) changes from a "predetermined control mode" to a "control mode other than the predetermined control mode". Alternatively, the fourth restriction condition is a condition that the control mode of the motor (50) changes from a "control mode other than the predetermined control mode" to "the predetermined control mode".

The fifth restriction condition is a condition that an integer multiple of the frequency of the voltage of the power source (60) is in the vicinity of an integer multiple or M/N multiple of the rotational frequency of the motor (50) in a case where the motor (50) is driven by AC power generated based on the power source power supplied from the power source (60). M and N are integers.

The sixth restriction condition is a condition that, in a case where the motor (50) is driven by the motor drive device (20) including the DC unit (22) that generates DC power corresponding to the power source power supplied from the power source (60) and the inverter (23) that converts the DC power generated by the DC unit (22) into AC power by a switching operation, the voltage of the DC unit (22) changes from a steady state to an unsteady state.

[Restriction Release Condition]

A restriction release condition according to Embodiment 7 includes at least two of first to sixth release conditions. Specifically, the first to sixth release conditions correspond to the first to sixth restriction conditions on a one-to-one basis. The restriction release condition includes release conditions corresponding to restriction conditions included in the estimation restriction condition among the first to sixth release conditions. In Embodiment 7, when all of the release conditions included in the restriction release condition are satisfied, the restriction release condition is satisfied. In this example, the restriction release condition includes all of the first to sixth release conditions.

The first release condition is a condition that the number of rotations of the motor (50) changes from the unsteady state to the steady state.

The second release condition is a condition that the pressure of a fluid flowing into the compressor (CC) or the pressure of a fluid flowing out of the compressor (CC) changes from the unsteady state to the steady state.

The third release condition is a condition that the temperature of a fluid flowing into the compressor (CC) or the temperature of a fluid flowing out of the compressor (CC) changes from the unsteady state to the steady state.

The fourth release condition is a condition (first condition) that the control mode of the motor (50) changes. For example, the fourth release condition is a condition that the control mode of the motor (50) changes from a "control mode other than the predetermined control mode" to "the predetermined control mode". Alternatively, the fourth release condition is a condition that the control mode of the motor (50) changes from the "predetermined control mode" to a "control mode other than the predetermined control mode".

Alternatively, the fourth release condition is a condition (second condition) that the estimation process is restricted in accordance with a change in the control mode of the motor (50) when the estimation restriction condition is a condition (fourth restriction condition) that the control mode of the motor (50) changes.

The fifth release condition is a condition that an integer multiple of the frequency of the voltage of the power source (60) is outside the vicinity of an integer multiple or M/N multiple of the rotational frequency of the motor (50) in a case where the motor (50) is driven by AC power generated based on the power source power supplied from the power source (60).

The sixth release condition is a condition that, in a case where the motor (50) is driven by the motor drive device (20) including the DC unit (22) that generates DC power corresponding to the power source power supplied from the power source (60) and the inverter (23) that converts the DC power generated by the DC unit (22) into AC power by a switching operation, the voltage of the DC unit (22) changes from the unsteady state to the steady state.

In a restriction process according to Embodiment 7, when at least one of the restriction conditions included in the estimation restriction condition is satisfied, the control unit (31) restricts the estimation process so that a predetermined estimation result is output, and when all of the release conditions included in the restriction release condition are satisfied, the control unit (31) releases the restriction of the estimation process after a predetermined standby release condition is satisfied.

[Effects of Embodiment 7]

In Embodiment 7, effects similar to those of Embodiment 1 can be obtained.

In Embodiment 7, the estimation restriction condition includes at least two restriction conditions of the first to sixth restriction conditions. The restriction release condition includes at least two release conditions of the first to sixth release conditions. In other words, Embodiment 7 involves restricting the estimation process and releasing the restriction of the estimation process, based on at least two of the following (1) to (6).

(1) The state of the number of rotations of the motor (50)
(2) The state of the pressure of a fluid flowing into the compressor (CC) or the pressure of a fluid flowing out of the compressor (CC)
(3) The state of the temperature of a fluid flowing into the compressor (CC) or the temperature of a fluid flowing out of the compressor (CC)
(4) The change in the control mode of the motor (50)
(5) The relationship between an integer multiple of the frequency of the voltage of the power source (60) and an integer multiple or M/N multiple of the rotational frequency of the motor (50)
(6) The state of the voltage of the DC unit (22)

In Embodiment 7, above (1) to (6) correlate with an unintended variation that occurs in the feature quantity calculated from the physical quantity obtained from the device (70) within the predetermined period. By monitoring above (1) to (6), it is possible to check whether an unintended variation is occurring in the feature quantity. Thus, by restricting the estimation process and releasing the restriction of the estimation process based on above (1) to (6), it is possible to appropriately restrict the estimation process and release the restriction of the estimation process.

(Modification of Embodiment 7)

The estimation restriction condition according to Embodiment 7 may include a seventh restriction condition. For example, the estimation restriction condition may include the first to seventh restriction conditions. The seventh restriction condition is a condition that the number of rotations of the motor (50) is a specific number of rotations and that the inflow pressure and the outflow pressure of the compressor (CC) are specific pressures.

For example, in a case where the compressor (CC) is a scroll compressor, the specific number of rotations and the specific pressures are set to the "number of rotations of the motor (50)" and the "inflow pressure and outflow pressure of the compressor (CC)", respectively, when the state of the compressor (CC) is a chipping state.

The chipping state is a state in which a movable scroll (not illustrated) separates from a fixed scroll (not illustrated) of the compressor (CC), which is a scroll compressor, resulting in an unstable behavior. When the state of the compressor (CC) is the chipping state, a gas fluid leak from a compression chamber formed between the fixed scroll and the movable scroll may change the internal pressure state of the compression chamber. The change in the internal pressure state of the compression chamber affects a physical quantity (e.g., a primary component of the current vector amplitude) obtained from the device (70), which may cause erroneous estimation in the estimation process.

The restriction release condition according to Embodiment 7 may include a seventh release condition. For example, the restriction release condition may include the first to seventh release conditions. The seventh release condition is a condition that the number of rotations of the motor (50) is not the specific number of rotations or the pressure of a fluid flowing into the compressor (CC) and the pressure of a fluid flowing out of the compressor (CC) are not the specific pressures.

(Embodiment 8)

A drive system (10) according to Embodiment 8 is different from the drive system (10) according to Embodiment 1 in the estimation restriction condition and the restriction release condition. Other configurations and processes of the drive system (10) according to Embodiment 8 are similar to the configurations and processes of the drive system (10) according to Embodiment 1. Further, the drive system (10) according to Embodiment 8 is mounted in, for example, the device (70) in which the compressor (CC) including the motor (50) is mounted.

In the drive system (10) according to Embodiment 8, the control device (30) is an example of a state estimation device that estimates the state of the device (70) in which the motor (50) is mounted.

[Estimation Restriction Condition]

An estimation restriction condition according to Embodiment 8 includes at least one of first to sixth restriction conditions. In Embodiment 8, when at least one of the restriction conditions included in the estimation restriction condition is satisfied, the estimation restriction condition is satisfied. In this example, the estimation restriction condition includes all of the first to sixth restriction conditions.

The first restriction condition is a condition that the number of rotations of the motor (50) changes from a steady state to an unsteady state.

The second restriction condition is a condition that the pressure of a fluid flowing into the compressor (CC) or the pressure of a fluid flowing out of the compressor (CC) changes from a steady state to an unsteady state in a case where the motor (50) is provided in the compressor (CC).

The third restriction condition is a condition that the temperature of a fluid flowing into the compressor (CC) or the temperature of a fluid flowing out of the compressor (CC) changes from a steady state to an unsteady state in a case where the motor (50) is provided in the compressor (CC).

The fourth restriction condition is a condition that the control mode of the motor (50) changes. For example, the fourth restriction condition is a condition that the control mode of the motor (50) changes from a "predetermined control mode" to a "control mode other than the predetermined control mode". Alternatively, the fourth restriction condition is a condition that the control mode of the motor (50) changes from a "control mode other than the predetermined control mode" to "the predetermined control mode".

The fifth restriction condition is a condition that an integer multiple of the frequency of the voltage of the power source (60) is in the vicinity of an integer multiple or M/N multiple of the rotational frequency of the motor (50) in a case where the motor (50) is driven by AC power generated based on the power source power supplied from the power source (60). M and N are integers.

The sixth restriction condition is a condition that, in a case where the motor (50) is driven by the motor drive device (20) including the DC unit (22) that generates DC power corresponding to the power source power supplied from the power source (60) and the inverter (23) that converts the DC power generated by the DC unit (22) into AC power by a switching operation, the voltage of the DC unit (22) changes from a steady state to an unsteady state.

[Restriction Release Condition]

A restriction release condition according to Embodiment 8 includes at least one of first to sixth release conditions. Specifically, the first to sixth release conditions correspond to the first to sixth restriction conditions on a one-to-one basis. The restriction release condition includes a release condition corresponding to a restriction condition included in the estimation restriction condition among the first to sixth release conditions. In Embodiment 8, when all of the release

**EP 4 693 887 A1**

conditions included in the restriction release condition are satisfied, the restriction release condition is satisfied. In this example, the restriction release condition includes all of the first to sixth release conditions.

The first release condition is a condition that the number of rotations of the motor (50) changes from the unsteady state to the steady state.

The second release condition is a condition that the pressure of a fluid flowing into the compressor (CC) or the pressure of a fluid flowing out of the compressor (CC) changes from the unsteady state to the steady state in a case where the motor (50) is provided in the compressor (CC).

The third release condition is a condition that the temperature of a fluid flowing into the compressor (CC) or the temperature of a fluid flowing out of the compressor (CC) changes from the unsteady state to the steady state in a case where the motor (50) is provided in the compressor (CC).

The fourth release condition is a condition (first condition) that the control mode of the motor (50) changes. For example, the fourth release condition is a condition that the control mode of the motor (50) changes from a "control mode other than the predetermined control mode" to "the predetermined control mode". Alternatively, the fourth release condition is a condition that the control mode of the motor (50) changes from the "predetermined control mode" to a "control mode other than the predetermined control mode".

Alternatively, the fourth release condition is a condition (second condition) that the estimation process is restricted in accordance with a change in the control mode of the motor (50) when the estimation restriction condition is a condition (fourth restriction condition) that the control mode of the motor (50) changes.

The fifth release condition is a condition that an integer multiple of the frequency of the voltage of the power source (60) is outside the vicinity of an integer multiple or M/N multiple of the rotational frequency of the motor (50) in a case where the motor (50) is driven by AC power generated based on the power source power supplied from the power source (60).

The sixth release condition is a condition that, in a case where the motor (50) is driven by the motor drive device (20) including the DC unit (22) that generates DC power corresponding to the power source power supplied from the power source (60) and the inverter (23) that converts the DC power generated by the DC unit (22) into AC power by a switching operation, the voltage of the DC unit (22) changes from the unsteady state to the steady state.

In a restriction process according to Embodiment 8, when at least one of the restriction conditions included in the estimation restriction condition is satisfied, the control unit (31) restricts the estimation process so that a predetermined estimation result is output, and when all of the release conditions included in the restriction release condition are satisfied, the control unit (31) releases the restriction of the estimation process after a predetermined standby release condition is satisfied.

[Effects of Embodiment 8]

In Embodiment 8, effects similar to those of Embodiment 1 can be obtained.

In Embodiment 8, the estimation restriction condition includes at least one restriction condition of the first to sixth restriction conditions. The restriction release condition includes at least one release condition of the first to sixth release conditions. In other words, Embodiment 8 involves restricting the estimation process and releasing the restriction of the estimation process, based on at least one of the following (1) to (6).

(1) The state of the number of rotations of the motor (50)
(2) The state of the pressure of a fluid flowing into the compressor (CC) or the pressure of a fluid flowing out of the compressor (CC)
(3) The state of the temperature of a fluid flowing into the compressor (CC) or the temperature of a fluid flowing out of the compressor (CC)
(4) The change in the control mode of the motor (50)
(5) The relationship between an integer multiple of the frequency of the voltage of the power source (60) and an integer multiple or M/N multiple of the rotational frequency of the motor (50)
(6) The state of the voltage of the DC unit (22)

In Embodiment 8, above (1) to (6) correlate with an unintended variation that occurs in the feature quantity calculated from the physical quantity obtained from the device (70) within the predetermined period. By monitoring above (1) to (6), it is possible to check whether an unintended variation is occurring in the feature quantity. Thus, by restricting the estimation process and releasing the restriction of the estimation process based on above (1) to (6), it is possible to appropriately restrict the estimation process and release the restriction of the estimation process.

(Modification of Embodiment 8)

The estimation restriction condition according to Embodiment 8 may include a seventh restriction condition. For example, the estimation restriction condition may include the first to seventh restriction conditions. The "seventh restriction condition" according to a modification of Embodiment 8 is similar to the "seventh restriction condition" according to the modification of Embodiment 7.

The restriction release condition according to Embodiment 8 may include a seventh release condition. For example, the restriction release condition may include the first to seventh release conditions. The "seventh release condition" according to the modification of Embodiment 8 is similar to the "seventh release condition" according to the modification of Embodiment 7.

(Refrigeration System)

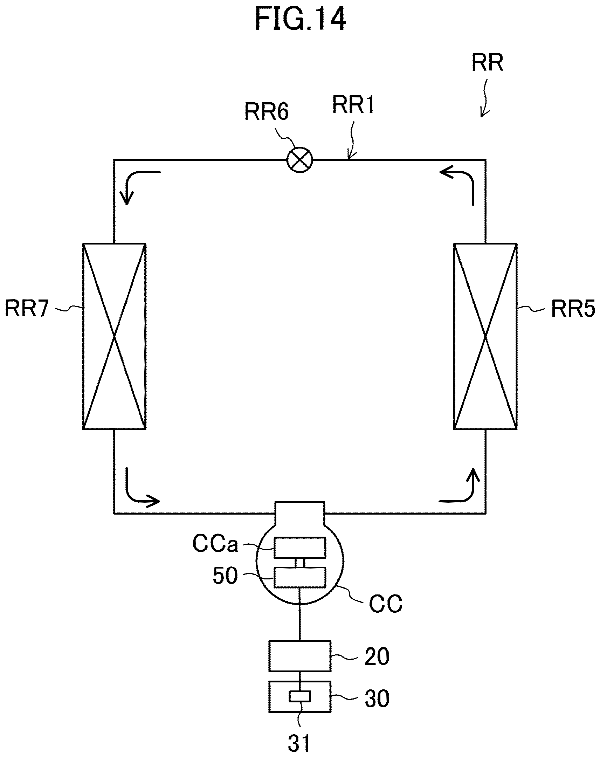

Fig. 14 illustrates a configuration of a refrigeration system (RR). The refrigeration system (RR) includes a refrigerant circuit (RR1) filled with a refrigerant, a motor drive device (20), and a control device (30). The motor drive device (20) and the control device (30) illustrated in Fig. 14 are the motor drive device (20) and the control device (30) according to any one of Embodiments 1 to 7.

The refrigerant circuit (RR1) includes a compressor (CC), a radiator (RR5), a decompression mechanism (RR6), and an evaporator (RR7). In this example, the decompression mechanism (RR6) is an expansion valve. The refrigerant circuit (RR1) performs a vapor compression refrigeration cycle.

The compressor (CC) includes a compression mechanism (CCa) and a motor (50). The compression mechanism (CCa) is coupled to the motor (50) by a shaft. The motor (50) rotationally drives the shaft to rotationally drive the compression mechanism (CCa). The motor drive device (20) drives the motor (50). The control device (30) estimates the state of the refrigeration system (RR) in which the compressor (CC) including the motor (50) is mounted.

In the refrigeration cycle, the refrigerant flowing out of the compressor (CC) dissipates heat in the radiator (RR5). The refrigerant flowing out of the radiator (RR5) is decompressed in the decompression mechanism (RR6) and evaporated in the evaporator (RR7). The refrigerant flowing out of the evaporator (RR7) flows into the compressor (CC).

In this example, the refrigeration system (RR) is an air conditioner. The air conditioner may be a cooling dedicated machine or a heating dedicated machine. Alternatively, the air conditioner may be an air conditioner that switches between cooling and heating. In this case, the air conditioner includes a switching mechanism (e.g., a fourway switching valve) that switches the circulation direction of the refrigerant. Alternatively, the refrigeration system (RR) may be a water heater, a chiller unit, a cooling apparatus for cooling inside air, or the like. The cooling apparatus cools air inside a refrigerator, a freezer, a container, or the like.

(Fan System)

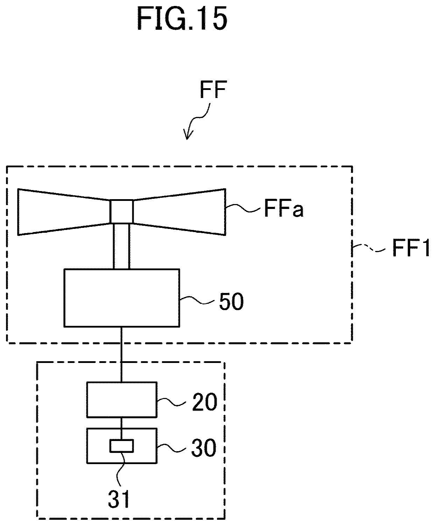

Fig. 15 illustrates a configuration of a fan system (FF). The fan system (FF) includes a fan (FF1), a motor drive device (20), and a control device (30). The motor drive device (20) and the control device (30) illustrated in Fig. 15 are the motor drive device (20) and the control device (30) according to any one of Embodiments 1 to 4.

The fan (FF1) includes a rotor (FFa) having blades, and a motor (50). The rotor (FFa) is coupled to the motor (50) by a shaft. The motor (50) rotationally drives the shaft to rotationally drive the rotor (FFa). The motor drive device (20) drives the motor (50). The control device (30) estimates the state of the fan system (FF) in which the motor (50) is mounted.

(Other Embodiments)

In the above description, the state of the device (70) may be the state of the device (70) as a whole, or may be the state of some elements included in the device (70). For example, when the device (70) is an "outdoor unit in which a compressor (CC) including a motor (50) is mounted", the state of the device (70) may be the state of the outdoor unit, the state of the compressor (CC), the state of the motor (50), or the state of any other element of the outdoor unit.

In the above description, the signal based on the current or voltage of the motor (50) has been described as an example of the physical quantity obtained from the device (70), but is not intended to be limiting. For example, the physical quantity may be a signal indicating a current supplied to the motor (50), a signal indicating a voltage applied to the motor (50), a signal indicating the number of rotations of the motor (50), a signal indicating vibration of the device (70), or a signal indicating sound of the device (70). The signal indicating the vibration of the device (70) may be acquired by a vibration sensor (not illustrated) provided in the device (70). The signal indicating the sound of the device (70) may be acquired by a microphone (not illustrated) provided in the device (70).

In the above description, the first frequency component (C1) illustrated in Figs. 3 and 4 has been described as an example of the feature quantity calculated from the physical quantity, but is not intended to be limiting. For example, the first frequency component (C1) may be a frequency component that is an integer multiple of the mechanical angular frequency of the motor (50), or may be a frequency component that is an integer fraction of the mechanical angular frequency of the motor (50). It is sufficient that the feature quantity be calculated from a physical quantity obtained from the device (70) within a predetermined period. For example, the feature quantity may be an effective value of the phase current or an average value of the current vector amplitude. Accordingly, the feature quantity may be a frequency component, an effective value, an average value, or the like, or may be any other value.

In the above description, a case where the presence or absence of an abnormality of the device (70) is estimated in the estimation process has been described as an example, but is not intended to be limiting.

For example, in the estimation process, the control unit (31) may estimate the degree of wear of a shaft (not illustrated) rotationally driven by the motor (50) or a bearing (not illustrated) of the shaft. In this case, the control unit (31) may estimate the degree of wear of the shaft or the bearing in accordance with the feature quantity, which is obtained by the calculation process, so that the degree of wear increases as the feature quantity increases. Examples of the "predetermined estimation result" output when the estimation process for estimating the degree of wear is restricted include an estimation result indicating that the degree of wear of the device (70) is unknown and an estimation result indicating that the estimation process is prohibited (stopped). The degree of wear is an example of the degree of deterioration.

In the estimation process, the control unit (31) may estimate the remaining life of the motor (50). In this case, the control unit (31) may estimate the remaining life of the motor (50) in accordance with the feature quantity, which is obtained by the calculation process, so that the remaining life decreases as the feature quantity increases. Examples of the "predetermined estimation result" output when the estimation process for estimating the remaining life is restricted include an estimation result indicating that the remaining life of the device (70) is unknown and an estimation result indicating that the estimation process is prohibited (stopped). The remaining life is an example of the degree of deterioration.

In the above description, the control unit (31) may be configured to perform the estimation process using an algorithm constructed by a neural network or machine learning (an algorithm for estimating a state based on a change in signal).

In the above description, the control unit (31) may be implemented by one processor or may be implemented by a plurality of processors. The control unit (31) may be implemented by a plurality of arithmetic processing devices (computers) that communicate with each other via a communication network.

In the above description, the process for "releasing the restriction of the estimation process after a predetermined standby release condition is satisfied when a predetermined restriction release condition is satisfied" may include a process for "releasing the restriction of the estimation process and outputting an estimation result obtained in the estimation process when the predetermined restriction release condition is satisfied and the duration of a state in which the estimation result obtained in the estimation process (e.g., the estimation process restricted by the second process as an example of the process for restricting the estimation process) is a predetermined estimation result (e.g., an estimation result indicating that the device (70) is abnormal) is greater than or equal to a predetermined time".

While the embodiments and the modifications have been described, it will be understood that various changes in form and detail may be made without departing from the spirit and scope of the appended claims. In addition, the elements according to the above embodiments and modifications and other embodiments may be appropriately combined or replaced.

For example, aspects of the present disclosure may be the following aspects.

[Example of State Estimation Device]

A state estimation device for estimating a state of a device (70) in which a motor (50) is mounted, the state estimation device including:

> a control unit (31),
> the control unit (31) being configured to perform

>> a calculation process for calculating a feature quantity from a physical quantity obtained from the device (70) within a predetermined period,
>> an estimation process for estimating the state of the device (70), based on the feature quantity calculated by the calculation process, and
>> a restriction process for restricting the estimation process so that a predetermined estimation result is output when a predetermined estimation restriction condition is satisfied, and releasing restriction of the estimation process after a predetermined standby release condition is satisfied when a predetermined restriction release condition is satisfied, wherein

> the restriction release condition includes at least one of

a first release condition that a number of rotations of the motor (50) changes from an unsteady state to a steady state,

a second release condition that, when the motor (50) is provided in a compressor (CC), a pressure of a fluid flowing into the compressor (CC) or a pressure of a fluid flowing out of the compressor (CC) changes from an unsteady state to a steady state,

a third release condition that, when the motor (50) is provided in the compressor (CC), a temperature of the fluid flowing into the compressor (CC) or a temperature of the fluid flowing out of the compressor (CC) changes from an unsteady state to a steady state,

a fourth release condition that is a first condition that a control mode of the motor (50) changes after the estimation process is restricted, or a second condition that, when the estimation restriction condition is a condition that the control mode of the motor (50) changes, the estimation process is restricted in accordance with a change in the control mode of the motor (50),

a fifth release condition that, in a case where the motor (50) is driven by AC power generated based on power source power supplied from a power source (60), an integer multiple of a frequency of a voltage of the power source (60) is outside a vicinity of an integer multiple or M/N multiple of a rotational frequency of the motor (50) (M and N being integers), and

a sixth release condition that, in a case where the motor (50) is driven by a motor drive device (20) including a DC unit (22) configured to generate DC power corresponding to the power source power supplied from the power source (60) and a conversion unit (23) configured to convert the DC power generated by the DC unit (22) into AC power by a switching operation, a voltage of the DC unit (22) changes from an unsteady state to a steady state, and

the restriction release condition is satisfied when all of conditions included in the restriction release condition are satisfied.

[Example of State Estimation Method]

A state estimation method for estimating a state of a device (70) in which a motor (50) is mounted, the state estimation method including:

a calculation step of calculating a feature quantity from a physical quantity obtained from the device (70) within a predetermined period;

an estimation step of estimating the state of the device (70), based on the feature quantity calculated in the calculation step; and

a restriction step of restricting the estimation step so that a predetermined estimation result is output when a predetermined estimation restriction condition is satisfied, and releasing restriction of the estimation step after a predetermined standby release condition is satisfied when a predetermined restriction release condition is satisfied, wherein

the restriction release condition includes at least one of

a first release condition that a number of rotations of the motor (50) changes from an unsteady state to a steady state,

a second release condition that, when the motor (50) is provided in a compressor (CC), a pressure of a fluid flowing into the compressor (CC) or a pressure of a fluid flowing out of the compressor (CC) changes from an unsteady state to a steady state,

a third release condition that, when the motor (50) is provided in the compressor (CC), a temperature of the fluid flowing into the compressor (CC) or a temperature of the fluid flowing out of the compressor (CC) changes from an unsteady state to a steady state,

a fourth release condition that is a first condition that a control mode of the motor (50) changes after the estimation process is restricted, or a second condition that, when the estimation restriction condition is a condition that the control mode of the motor (50) changes, the estimation process is restricted in accordance with a change in the control mode of the motor (50),

a fifth release condition that, in a case where the motor (50) is driven by AC power generated based on power source power supplied from a power source (60), an integer multiple of a frequency of a voltage of the power source (60) is outside a vicinity of an integer multiple or M/N multiple of a rotational frequency of the motor (50) (M and N being integers), and

a sixth release condition that, in a case where the motor (50) is driven by a motor drive device (20) including a DC unit (22) configured to generate DC power corresponding to the power source power supplied from the power source (60) and a conversion unit (23) configured to convert the DC power generated by the DC unit (22) into AC power by a switching operation, a voltage of the DC unit (22) changes from an unsteady state to a steady state, and

the restriction release condition is satisfied when all of conditions included in the restriction release condition are satisfied.

(Overview of Embodiments)

To summarize the above description, the state estimation device (the control device (30)) according to the embodiments relates to a state estimation device for estimating a state of a device (70) including a motor (50). The state estimation device includes a control unit (31).

The control unit (31) performs a calculation process for calculating a feature quantity from a physical quantity obtained from the device (70) within a predetermined period, an estimation process for estimating the state of the device (70), based on the feature quantity calculated by the calculation process, and a restriction process for restricting the estimation process so that a predetermined estimation result is output when a predetermined estimation restriction condition is satisfied, maintaining restriction of the estimation process until a predetermined standby release condition is satisfied when a predetermined restriction release condition is satisfied, and releasing the restriction of the estimation process after the predetermined standby release condition is satisfied.

The physical quantity is a quantity that varies in accordance with the rotation of the motor (50). The feature quantity is a quantity that varies in accordance with the state of the device (70). The state of the device (70) includes at least one of an abnormality of the motor (50), a degree of deterioration of the motor (50), an abnormality of an element driven by the motor (50), and a degree of deterioration of the element driven by the motor (50). The estimation restriction condition is a condition in which there is a possibility of occurrence of erroneous estimation in the estimation process. The restriction release condition is a condition in which the erroneous estimation in the estimation process is suppressed.

For example, the "possibility of occurrence of erroneous estimation in the estimation process" in the estimation restriction condition is lower than the "possibility of occurrence of erroneous estimation in the estimation process" in the restriction release condition. The estimation restriction condition is a condition that the operation state of the motor (50) or the operation state of an element operating in conjunction with the motor (50) is not a "predetermined normal operation state" but a "non-normal operation state in which an unintended variation (noise that causes erroneous estimation in the estimation process) is more likely to occur in the feature quantity than in the normal operation state". The restriction release condition is a condition that the operation state of the motor (50) or the operation state of the element operating in conjunction with the motor (50) is the "predetermined normal operation state" described above. The element operating in conjunction with the motor (50) includes at least one of an "element that drives the motor (50)" and an "element that is driven by the motor (50)".

Examples of the operation state of the motor (50) include the state of the number of rotations (or rotational frequency) of the motor (50), and the state of the control mode of the motor (50). Examples of the state of the element that drives the motor (50) include the state of the voltage of the DC unit (22) of the motor drive device (20). Examples of the state of the element that is driven by the motor (50) include the state of the pressure of a fluid flowing into the compressor (CC) (or a fluid flowing out of the compressor (CC)), and the state of the temperature of a fluid flowing into the compressor (CC) (or a fluid flowing out of the compressor (CC)).

In the above configuration, the estimation process is restricted so that a predetermined estimation result is output when a predetermined estimation restriction condition is satisfied. Thus, the erroneous estimation of the state of the device (70) can be appropriately suppressed. In addition, by restricting the estimation process based on the satisfaction of a predetermined restriction release condition, it is possible to appropriately release the restriction of the estimation process.

In the above configuration, when a predetermined restriction release condition is satisfied, the restriction of the estimation process is maintained until a predetermined standby release condition is satisfied, and, after the predetermined standby release condition is satisfied, the restriction of the estimation process is released. This configuration can release the restriction of the estimation process after stabilizing the feature quantity calculated in the calculation process, compared to a case where the restriction of the estimation process is released without waiting for the predetermined standby release condition to be satisfied. Thus, it is possible to suppress erroneous estimation of the state of the device (70) after the restriction of the estimation process is released.

The state estimation method according to the embodiments relates to a state estimation method for estimating a state of a device (70) including a motor (50). The state estimation method includes a calculation step of calculating a feature quantity from a physical quantity obtained from the device (70) within a predetermined period, an estimation step of estimating the state of the device (70), based on the feature quantity calculated in the calculation step, and a restriction step of restricting the estimation step so that a predetermined estimation result is output when a predetermined estimation restriction condition is satisfied, maintaining restriction of the estimation step until a predetermined standby release condition is satisfied when a predetermined restriction release condition is satisfied, and releasing the restriction of the estimation step after the predetermined standby release condition is satisfied.

As in the state estimation device, the physical quantity is a quantity that varies in accordance with the rotation of the motor (50). The feature quantity is a quantity that varies in accordance with the state of the device (70). The state of the device (70) includes at least one of an abnormality of the motor (50), a degree of deterioration of the motor (50), an abnormality of an element driven by the motor (50), and a degree of deterioration of the element driven by the motor (50). The estimation restriction condition is a condition in which there is a possibility of occurrence of erroneous estimation in the estimation step. The restriction release condition is a condition in which the erroneous estimation in the estimation step is suppressed.

In the above method, the estimation step is restricted so that a predetermined estimation result is output when a predetermined estimation restriction condition is satisfied. Thus, the erroneous estimation of the state of the device (70) can be appropriately suppressed. In addition, by restricting the estimation step based on the satisfaction of a predetermined restriction release condition, it is possible to appropriately release the restriction of the estimation step.

In the above method, when a predetermined restriction release condition is satisfied, the restriction of the estimation step is maintained until a predetermined standby release condition is satisfied, and, after the predetermined standby release condition is satisfied, the restriction of the estimation step is released. This can release the restriction of the estimation step after stabilizing the feature quantity calculated in the calculation step, compared to a case where the restriction of the estimation step is released without waiting for the predetermined standby release condition to be satisfied. Thus, it is possible to suppress erroneous estimation of the state of the device (70) after the restriction of the estimation step is released.

The restriction release condition may be a condition that the number of rotations of the motor (50) changes from an unsteady state to a steady state.

The device (70) may include a compressor (CC) including the motor (50). The restriction release condition may be a condition that the pressure of a fluid flowing into the compressor (CC) or the pressure of a fluid flowing out of the compressor (CC) changes from the unsteady state to the steady state.

The device (70) may include a compressor (CC) including the motor (50). The restriction release condition may be a condition that the temperature of a fluid flowing into the compressor (CC) or the temperature of a fluid flowing out of the compressor (CC) changes from the unsteady state to the steady state.

Alternatively, the restriction release condition may be a first condition that the control mode of the motor (50) changes after the estimation process is restricted, or a second condition that when the estimation restriction condition is a condition that the control mode of the motor (50) changes, the estimation process is restricted in accordance with a change in the control mode of the motor (50).

The motor (50) may be driven by AC power generated based on the power source power supplied from the power source (60). The restriction release condition may be a condition that an integer multiple or M/N multiple of the rotational frequency of the motor (50) (M and N being integers) is outside the vicinity of an integer multiple of the frequency of the voltage of the power source (60). In this case, the feature quantity may be a frequency component that is an M/N multiple of the rotational frequency of the motor (50).

The motor (50) may be driven by a motor drive device (20) including a DC unit (22) that generates DC power corresponding to power source power supplied from the power source (60) and a conversion unit (23) that converts the DC power generated by the DC unit (22) into AC power by a switching operation. The restriction release condition may be a condition that the voltage of the DC unit (22) changes from the unsteady state to the steady state.

The device (70) may include a compressor (CC) including the motor (50), and the restriction release condition may include at least two of first to sixth release conditions. When all of the conditions included in the restriction release condition are satisfied, the restriction release condition may be satisfied.

The first release condition is a condition that the number of rotations of the motor (50) changes from the unsteady state to the steady state. The second release condition is a condition that the pressure of a fluid flowing into the compressor (CC) or the pressure of a fluid flowing out of the compressor (CC) changes from the unsteady state to the steady state. The third release condition is a condition that the temperature of a fluid flowing into the compressor (CC) or the temperature of a fluid flowing out of the compressor (CC) changes from the unsteady state to the steady state.

The fourth release condition is a first condition that a control mode of the motor (50) changes after the estimation process is restricted, or a second condition that, when the estimation restriction condition is a condition that the control mode of the motor (50) changes, the estimation process is restricted in accordance with a change in the control mode of the motor (50). The fifth release condition is a condition that an integer multiple or M/N multiple of the rotational frequency of the motor (50) (M and N being integers) is outside the vicinity of an integer multiple of the frequency of the voltage of the power source (60) when the motor (50) is driven by AC power generated based on the power source power supplied from the power source (60).

The sixth release condition is a condition that, in a case where the motor (50) is driven by the motor drive device (20) including the DC unit (22) that generates DC power corresponding to the power source power supplied from the power source (60) and the conversion unit (23) that converts the DC power generated by the DC unit (22) into AC power by a switching operation, the voltage of the DC unit (22) changes from the unsteady state to the steady state.

The physical quantity may be any one of a current supplied to the motor (50), a voltage applied to the motor (50), the number of rotations of the motor (50), vibration of the device (70), and sound of the device (70).

The feature quantity may be a frequency component.

The feature quantity is a quantity calculated from a physical quantity within a predetermined period. For example, the feature quantity may be a quantity indicating a change in the physical quantity over time within the predetermined period. Such a feature quantity can be obtained by sampling the physical quantity within the predetermined period at a predetermined sampling cycle. Alternatively, the feature quantity may be a quantity that changes in accordance with a change in the physical quantity over time within the predetermined period.

The estimation restriction condition may include a condition that the number of rotations of the motor (50) is a specific number of rotations and that the pressure of a fluid flowing into the compressor (CC) and the pressure of a fluid flowing out of the compressor (CC) are specific pressures.

Industrial Applicability

As described above, the present disclosure is useful as a state estimation technique.

Reference Signs List

| | |
|---|---|
| 10 | drive system |
| 20 | motor drive device |
| 21 | converter |
| 22 | DC unit |
| 23 | inverter (conversion unit) |
| 30 | control device (state estimation device) |
| 31 | control unit |
| 41 | phase current detection unit |
| 42 | electrical angular frequency detection unit |
| 50 | motor |
| 60 | power source |
| 70 | device |
| CC | compressor |
| RR | refrigeration system |
| RR1 | refrigerant circuit |
| FF | fan system |
| FF1 | fan |

**Claims**

1. A state estimation device for estimating a state of a device (70) including a motor (50), the state estimation device comprising:

a control unit (31),
the control unit (31) being configured to perform

a calculation process for calculating a feature quantity from a physical quantity obtained from the device (70) within a predetermined period,
an estimation process for estimating the state of the device (70), based on the feature quantity calculated by the calculation process, and
a restriction process for restricting the estimation process so that a predetermined estimation result is output when a predetermined estimation restriction condition is satisfied, maintaining restriction of the estimation process until a predetermined standby release condition is satisfied when a predetermined restriction release condition is satisfied, and releasing the restriction of the estimation process after the predetermined standby release condition is satisfied, wherein

the physical quantity is a quantity that varies in accordance with rotation of the motor (50),
the feature quantity is a quantity that varies in accordance with the state of the device (70),
the state of the device (70) includes at least one of an abnormality of the motor (50), a degree of deterioration of the motor (50), an abnormality of an element driven by the motor (50), and a degree of deterioration of the element driven by the motor (50),
the estimation restriction condition is a condition in which there is a possibility of occurrence of erroneous estimation in the estimation process, and
the restriction release condition is a condition in which the erroneous estimation in the estimation process is suppressed.

2. The state estimation device according to claim 1, wherein
the restriction release condition is a condition that a number of rotations of the motor (50) changes from an unsteady state to a steady state.

3. The state estimation device according to claim 1, wherein

the device (70) includes a compressor (CC) including the motor (50), and
the restriction release condition is a condition that a pressure of a fluid flowing into the compressor (CC) or a pressure of a fluid flowing out of the compressor (CC) changes from an unsteady state to a steady state.

4. The state estimation device according to claim 1, wherein

the device (70) includes a compressor (CC) including the motor (50), and
the restriction release condition is a condition that a temperature of a fluid flowing into the compressor (CC) or a temperature of a fluid flowing out of the compressor (CC) changes from an unsteady state to a steady state.

5. The state estimation device according to claim 1, wherein
the restriction release condition is a first condition that a control mode of the motor (50) changes after the estimation process is restricted, or a second condition that, when the estimation restriction condition is a condition that the control mode of the motor (50) changes, the estimation process is restricted in accordance with a change in the control mode of the motor (50).

6. The state estimation device according to claim 1, wherein

the motor (50) is driven by AC power generated based on power source power supplied from a power source (60), and
the restriction release condition is a condition that an integer multiple or M/N multiple of a rotational frequency of the motor (50) (M and N being integers) is outside a vicinity of an integer multiple of a frequency of a voltage of the power source (60).

7. The state estimation device according to claim 1, wherein

the motor (50) is driven by a motor drive device (20) including a DC unit (22) configured to generate DC power corresponding to power source power supplied from a power source (60) and a conversion unit (23) configured to convert the DC power generated by the DC unit (22) into AC power by a switching operation, and
the restriction release condition is a condition that a voltage of the DC unit (22) changes from an unsteady state to a steady state.

8. The state estimation device according to claim 1, wherein

the device (70) includes a compressor (CC) including the motor (50),
the restriction release condition includes at least two of

a first release condition that a number of rotations of the motor (50) changes from an unsteady state to a steady state,
a second release condition that a pressure of a fluid flowing into the compressor (CC) or a pressure of a fluid flowing out of the compressor (CC) changes from an unsteady state to a steady state,
a third release condition that a temperature of the fluid flowing into the compressor (CC) or a temperature of the fluid flowing out of the compressor (CC) changes from an unsteady state to a steady state,

a fourth release condition that is a first condition that a control mode of the motor (50) changes after the estimation process is restricted, or a second condition that, when the estimation restriction condition is a condition that the control mode of the motor (50) changes, the estimation process is restricted in accordance with a change in the control mode of the motor (50),

a fifth release condition that, in a case where the motor (50) is driven by AC power generated based on power source power supplied from a power source (60), an integer multiple or M/N multiple of a rotational frequency of the motor (50) (M and N being integers) is outside a vicinity of an integer multiple of a frequency of a voltage of the power source (60), and

a sixth release condition that, in a case where the motor (50) is driven by a motor drive device (20) including a DC unit (22) configured to generate DC power corresponding to the power source power supplied from the power source (60) and a conversion unit (23) configured to convert the DC power generated by the DC unit (22) into AC power by a switching operation, a voltage of the DC unit (22) changes from an unsteady state to a steady state, and

the restriction release condition is satisfied when all of conditions included in the restriction release condition are satisfied.

9. The state estimation device according to any one of claims 1 to 8, wherein
the physical quantity is any one of a current supplied to the motor (50), a voltage applied to the motor (50), a number of rotations of the motor (50), vibration of the device (70), and sound of the device (70).

10. The state estimation device according to any one of claims 1 to 9, wherein
the feature quantity is a frequency component.

11. The state estimation device according to claim 3 or 4, wherein
the estimation restriction condition includes a condition that a number of rotations of the motor (50) is a specific number of rotations and that the pressure of the fluid flowing into the compressor (CC) and the pressure of the fluid flowing out of the compressor (CC) are specific pressures.

12. A drive system comprising:

a motor drive device (20) configured to drive a motor (50) mounted in a device (70); and
a state estimation device configured to estimate a state of the device (70), wherein
the state estimation device is the state estimation device according to any one of claims 1 to 11.

13. A refrigeration system comprising:

a refrigerant circuit (RR1) including a compressor (CC) including a motor (50); and
a state estimation device, wherein
the state estimation device is the state estimation device according to any one of claims 1 to 11, and is configured to estimate a state of the refrigeration system.

14. A fan system comprising:

a fan (FF1);
a motor (50) configured to drive the fan (FF1); and
a state estimation device, wherein
the state estimation device is the state estimation device according to any one of claims 1, 2, and 5 to 7, and is configured to estimate a state of the fan system.

15. A state estimation method for estimating a state of a device (70) including a motor (50), the state estimation method comprising:

a calculation step of calculating a feature quantity from a physical quantity obtained from the device (70) within a predetermined period;
an estimation step of estimating the state of the device (70), based on the feature quantity calculated in the calculation step; and

a restriction step of restricting the estimation step so that a predetermined estimation result is output when a predetermined estimation restriction condition is satisfied, maintaining restriction of the estimation step until a predetermined standby release condition is satisfied when a predetermined restriction release condition is satisfied, and releasing the restriction of the estimation step after the predetermined standby release condition is satisfied, wherein

the physical quantity is a quantity that varies in accordance with rotation of the motor (50),

the feature quantity is a quantity that varies in accordance with the state of the device (70),

the state of the device (70) includes at least one of an abnormality of the motor (50), a degree of deterioration of the motor (50), an abnormality of an element driven by the motor (50), and a degree of deterioration of the element driven by the motor (50),

the estimation restriction condition is a condition in which there is a possibility of occurrence of erroneous estimation in the estimation step, and

the restriction release condition is a condition in which the erroneous estimation in the estimation step is suppressed.

16. The state estimation method according to claim 15, wherein
the restriction release condition is a condition that a number of rotations of the motor (50) changes from an unsteady state to a steady state.

17. The state estimation method according to claim 15, wherein

the device (70) includes a compressor (CC) including the motor (50), and

the restriction release condition is a condition that a pressure of a fluid flowing into the compressor (CC) or a pressure of a fluid flowing out of the compressor (CC) changes from an unsteady state to a steady state.

18. The state estimation method according to claim 15, wherein

the device (70) includes a compressor (CC) including the motor (50), and

the restriction release condition is a condition that a temperature of a fluid flowing into the compressor (CC) or a temperature of a fluid flowing out of the compressor (CC) changes from an unsteady state to a steady state.

19. The state estimation method according to claim 15, wherein
the restriction release condition is a first condition that a control mode of the motor (50) changes after the estimation step is restricted, or a second condition that, when the estimation restriction condition is a condition that the control mode of the motor (50) changes, the estimation step is restricted in accordance with a change in the control mode of the motor (50).

20. The state estimation method according to claim 15, wherein

the motor (50) is driven by AC power generated based on power source power supplied from a power source (60), and

the restriction release condition is a condition that an integer multiple or M/N multiple of a rotational frequency of the motor (50) (M and N being integers) is outside a vicinity of an integer multiple of a frequency of a voltage of the power source (60).

21. The state estimation method according to claim 15, wherein

the motor (50) is driven by a motor drive device (20) including a DC unit (22) configured to generate DC power corresponding to power source power supplied from a power source (60) and a conversion unit (23) configured to convert the DC power generated by the DC unit (22) into AC power by a switching operation, and

the restriction release condition is a condition that a voltage of the DC unit (22) changes from an unsteady state to a steady state.

22. The state estimation method according to claim 15, wherein

the device (70) includes a compressor (CC) including the motor (50),

the restriction release condition includes at least two of

a first release condition that a number of rotations of the motor (50) changes from an unsteady state to a steady state,

a second release condition that a pressure of a fluid flowing into the compressor (CC) or a pressure of a fluid flowing out of the compressor (CC) changes from an unsteady state to a steady state,

a third release condition that a temperature of the fluid flowing into the compressor (CC) or a temperature of the fluid flowing out of the compressor (CC) changes from an unsteady state to a steady state,

a fourth release condition that is a first condition that a control mode of the motor (50) changes after the estimation step is restricted, or a second condition that, when the estimation restriction condition is a condition that the control mode of the motor (50) changes, the estimation step is restricted in accordance with a change in the control mode of the motor (50),

a fifth release condition that, in a case where the motor (50) is driven by AC power generated based on power source power supplied from a power source (60), an integer multiple or M/N multiple of a rotational frequency of the motor (50) (M and N being integers) is outside a vicinity of an integer multiple of a frequency of a voltage of the power source (60), and

a sixth release condition that, in a case where the motor (50) is driven by a motor drive device (20) including a DC unit (22) configured to generate DC power corresponding to the power source power supplied from the power source (60) and a conversion unit (23) configured to convert the DC power generated by the DC unit (22) into AC power by a switching operation, a voltage of the DC unit (22) changes from an unsteady state to a steady state, and

the restriction release condition is satisfied when all of conditions included in the restriction release condition are satisfied.

23. A state estimation program for causing a computer to execute the state estimation method according to any one of claims 15 to 22.

# FIG.1

EP 4 693 887 A1

# FIG.2

START

S101
ESTIMATION RESTRICTION
CONDITION SATISFIED? — NO

YES

S102
RESTRICT ESTIMATION
PROCESS

S103
RESTRICTION RELEASE
CONDITION SATISFIED? — NO

YES

S104
STANDBY RELEASE
CONDITION SATISFIED? — NO

YES

S105
RELEASE RESTRICTION OF
ESTIMATION PROCESS

RETURN

RESTRICTION
PROCESS ⟹

CALCULATION
PROCESS

ESTIMATION
PROCESS

FEATURE QUANTITY

ESTIMATION RESULT

# FIG.3

$$\sqrt{(i_u^2 + i_v^2 + i_w^2)}$$

$i_u$    $i_v$    $i_w$

EP 4 693 887 A1

# FIG.4

EP 4 693 887 A1

# FIG.5

AMPLITUDE

$f_0 - \frac{1}{3}f_m$

$f_0$

$f_0 + \frac{1}{3}f_m$

$f_0 + f_m$

Cs

Cs

C1

C1

$f_m$

FREQUENCY

EP 4 693 887 A1

# FIG.6

START

ACQUIRE FIRST FREQUENCY COMPONENT — S11

FIRST FREQUENCY COMPONENT GREATER THAN OR EQUAL TO UPPER LIMIT VALUE? — S12

NO

YES — S13

ESTIMATE ABNORMAL STATE

ESTIMATE NORMAL STATE — S14

END

# FIG.7

START

ACQUIRE RATE OF CHANGE IN FIRST FREQUENCY COMPONENT — S21

RATE OF CHANGE GREATER THAN OR EQUAL TO UPPER LIMIT VALUE? — S22

NO

YES — S23

ESTIMATE ABNORMAL STATE

ESTIMATE NORMAL STATE — S24

END

# FIG.8

FIRST FREQUENCY
COMPONENT
(AMPLITUDE)

TIME

RATE OF CHANGE

UPPER
LIMIT
VALUE

TIME

$t_1$          $t_2$  $t_3$

# FIG.9

START

S31

ACQUIRE CUMULATIVE TIME OF
TIME DURING WHICH FIRST FREQUENCY
COMPONENT IS GREATER THAN OR
EQUAL TO UPPER LIMIT VALUE

S32

CUMULATIVE TIME GREATER THAN
OR EQUAL TO UPPER LIMIT VALUE?

NO

YES

S33

ESTIMATE ABNORMAL STATE

S34

ESTIMATE NORMAL STATE

END

# FIG.10

# FIG.11

START

↓

ACQUIRE PROPORTION
(TIME PROPORTION) OF UPPER LIMIT
VALUE EXCEEDING TIME WITHIN
DETERMINATION TIME — S41

↓

TIME PROPORTION EXCEEDING
THRESHOLD VALUE? — S42

NO →

↓ YES — S43

ESTIMATE ABNORMAL STATE       ESTIMATE NORMAL STATE — S44

↓

END

# FIG.12

FIRST FREQUENCY
COMPONENT
(AMPLITUDE)

UPPER
LIMIT
VALUE

$t_1$   $t_2$   TIME

T1   T2

T0

# FIG.13

# FIG.14

# FIG.15

FF

FFa

FF1

50

20

30

31

## INTERNATIONAL SEARCH REPORT

| International application No. |
| --- |
| **PCT/JP2024/013257** |

| A. | CLASSIFICATION OF SUBJECT MATTER |
| --- | --- |

*H02P 29/024*(2016.01)i
FI: H02P29/024

According to International Patent Classification (IPC) or to both national classification and IPC

| B. | FIELDS SEARCHED |
| --- | --- |

Minimum documentation searched (classification system followed by classification symbols)

H02P29/024

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2022-39968 A (TAIDA ELECTRONIC IND CO., LTD.) 10 March 2022 (2022-03-10) paragraphs [0001]-[0060], fig. 1-7 | 1-23 |
| A | WO 2022/003758 A1 (MITSUBISHI ELECTRIC CORPORATION) 06 January 2022 (2022-01-06) paragraphs [0001]-[0091], fig. 1-15 | 1-23 |
| A | JP 2014-23370 A (SHIBAURA INSTITUTE OF TECHNOLOGY) 03 February 2014 (2014-02-03) paragraphs [0001]-[0040], fig. 1-4 | 1-23 |

☐ Further documents are listed in the continuation of Box C.   ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **02 May 2024** | **21 May 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

International application No.

**PCT/JP2024/013257**

| Patent document<br>cited in search report | | | Publication date<br>(day/month/year) | Patent family member(s) | | | Publication date<br>(day/month/year) |
|---|---|---|---|---|---|---|---|
| JP | 2022-39968 | A | 10 March 2022 | US | 2022/0069752 | A1 | |
| | | | | paragraphs [0001]-[0055], fig.<br>1-7 | | | |
| | | | | EP | 3961912 | A1 | |
| | | | | CN | 114114068 | A | |
| WO | 2022/003758 | A1 | 06 January 2022 | KR | 10-2023-0010708 | A | |
| | | | | CN | 115885469 | A | |
| | | | | JP | 6824494 | B1 | |
| JP | 2014-23370 | A | 03 February 2014 | (Family: none) | | | |

Form PCT/ISA/210 (patent family annex) (July 2022)

**EP 4 693 887 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020067334 A
- JP 6103031 B